# EUROPEAN PATENT APPLICATION

(11) **EP 4 672 879 A1**
(43) Date of publication of application: **31.12.2025**
(21) Application number: 24760222.0
(22) Date of filing: 14.02.2024
(51) Int. Cl.: H05K 5/03, G06F 1/16

(54) **ELECTRONIC DEVICE AND EXTERIOR PANEL**

(30) Priority: 21.02.2023 JP 2023025544
(71) Applicant: Sony Interactive Entertainment Inc., Tokyo 108-0075 (JP)
(72) Inventor: MITO, Satoshi, Tokyo 108-0075 (JP); TAMAKI, Yuta, Tokyo 108-0075 (JP); ETO, Kazutaka, Tokyo 108-0075 (JP)
(74) Representative: Fish & Richardson P.C.
(86) International application number: PCT/JP2024/005082
(87) International publication number: WO 2024/176921

(57) **Abstract**

An electronic device (10) has a device body (20) having an upper surface (22a) and an exterior panel (51) covering the upper surface (22a). A partial panel (51L) constituting the exterior panel (51) has a back engaging part (53), a front engaging part (54), and a fitting part (55A). The device body (20) has a back engaged part (25a) configured to be engaged with the back engaging part (53), a front engaged part (26a) configured to be engaged with the front engaging part (54), and a fitted part (27A) configured to be fitted with the fitting part (55A). The back engaged part (25a) is positioned behind the back engaging part (53), and the front engaged part (26a) is positioned behind the front engaging part (54). The fitted part (27A) is fitted with the fitting part (55A) so as to restrain the partial panel (51L) from moving forward. Provided here is an electronic device of which the exterior panel is easy to detach from the device body.

## Description

### [Technical Field]

The present disclosure relates to an electronic device and an exterior panel.

### [Background Art]

PCT Patent Publication No. WO2021/193881 discloses an electronic device that may be used as a game apparatus or a moving image reproduction apparatus, for example. This electronic device has a device body that accommodates a circuit board, a cooling apparatus, and the like, and an exterior panel attached to an outer surface of the device body. When replacing a storage apparatus installed in the device body or exchanging the current exterior panel for a new one of a different color or a different pattern, a user of the device can detach the exterior panel from the device body.

### [Summary]

Since the above-mentioned exterior panel is attached to and detached from the device body by the user, it is preferred that the work of attaching or detaching the exterior panel be easy and simple.

An exemplary electronic device proposed according to the present disclosure has a device body having a first outer surface, and an exterior panel configured to cover the first outer surface. The exterior panel has a first engaging part, a second engaging part, and a fitting part, the first engaging part being positioned on a first side relative to a center of the exterior panel in a first direction, the second engaging part being positioned on a second side opposite to the first side in the first direction to a center of the exterior panel. The device body has a first engaged part, a second engaged part, and a fitted part, the first engaged part being configured to be engaged with the first engaging part, the second engaged part being configured to be engaged with the second engaging part, the fitted part being configured to be fitted with the fitting part. The first engaged part is positioned on the first side in the first direction relative to the first engaging part. The second engaged part is positioned on the first side in the first direction relative to the second engaging part. The fitted part is fitted with the fitting part so as to restrain the exterior panel from moving toward the second side in the first direction.

Another exemplary electronic device proposed according to the present disclosure has a device body having a first outer surface, and an exterior panel configured to cover the first outer surface. The exterior panel has a first edge and a second edge positioned opposite to each other in a first direction, a first engaging part formed on a side of the first edge relative to a center of the exterior panel in the first direction, and a second engaging part formed on a side of the second edge relative to a center of the exterior panel. When the first engaging part engages with the first engaged part and the second engaging part does not engage with the second engaged part, the first exterior panel is rotatable around the first engaging part in a direction in which the second edge is separated from the device body and in a direction in which the second edge approaches the device body. A distance from the second edge to the second engaging part is greater than a distance from the first edge to the first engaging part.

An exemplary exterior panel proposed according to the present disclosure has a first edge and a second edge positioned opposite to each other in a first direction, a first engaging part formed on a first side relative to a center of the exterior panel in the first direction, the first engaging part being configured to engage with a first engaged part formed on the device body, a second engaging part formed on a second side relative to a center of the exterior panel in the first direction, the second engaging part being configured to engage with a second engaged part formed on the device body, and a fitting part configured to fit with a fitted part formed on the device body. The first engaging part has a claw part protruding on the first side in the first direction. The second engaging part has a claw part protruding on the first side in the first direction.

Another exemplary exterior panel proposed according to the present disclosure has a first edge and a second edge positioned opposite to each other in a first direction, a first engaging part formed on a side of the first edge relative to a center of the exterior panel in the first direction, the first engaging part being configured to engage with a first engaged part formed on the device body, and a second engaging part formed on a side of the second edge relative to a center of the exterior panel in the first direction, the second engaging part being configured to engage with a second engaged part formed on the device body. A distance from the second edge to the second engaging part is greater than a distance from the first edge to the second engaging part.

### [Brief Description of Drawings]

[FIG. 1A]

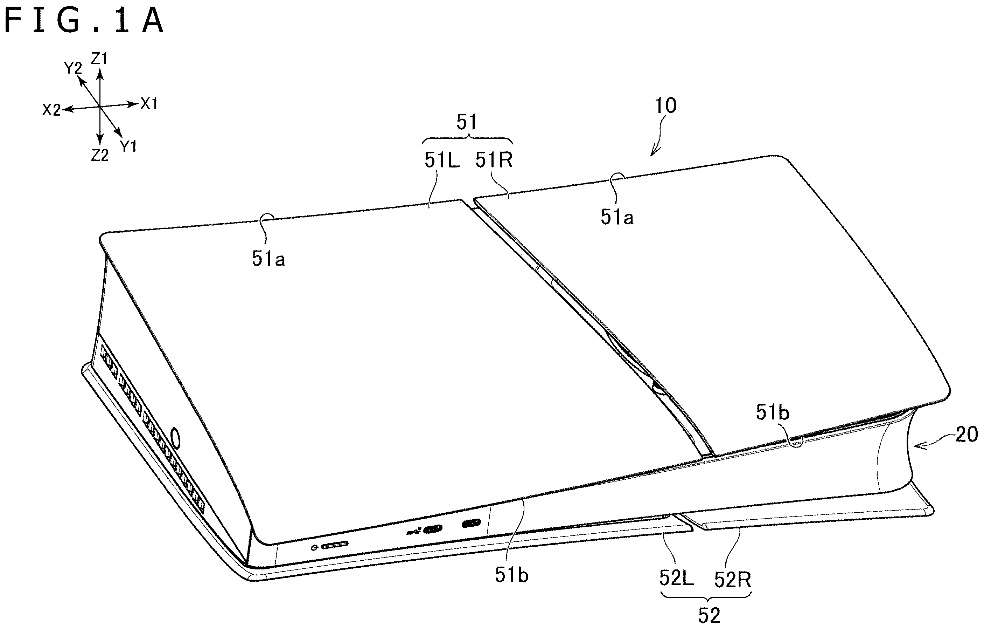

   FIG. 1A is a perspective view depicting an exemplary electronic device proposed according to the present disclosure.
[FIG. 1B]

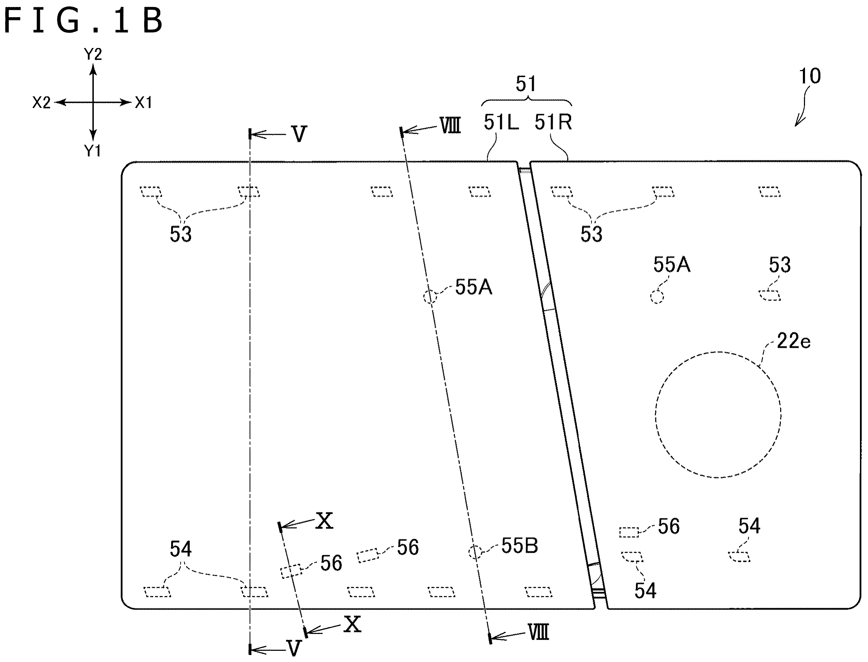

   FIG. 1B is a plan view of the electronic device.
[FIG. 1C]

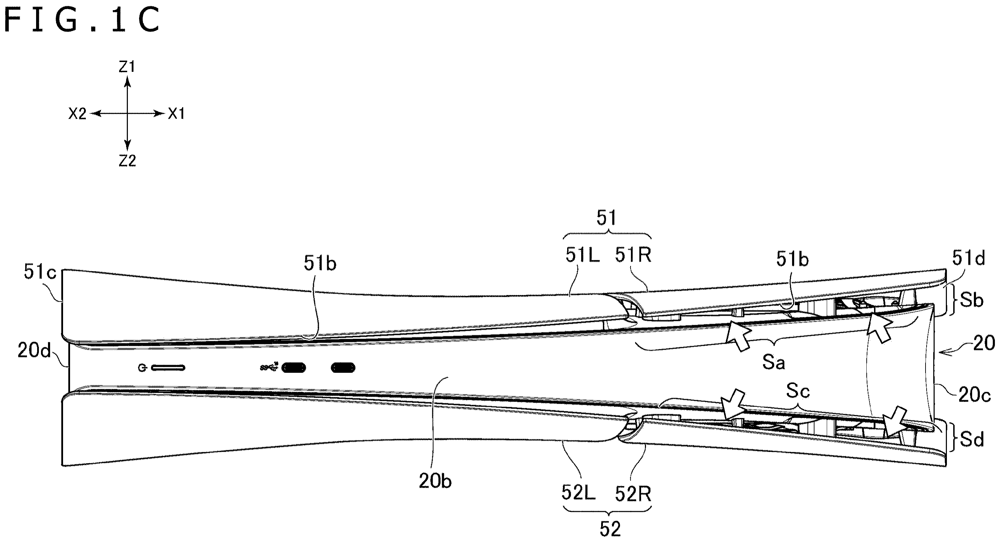

   FIG. 1C is a front view of the electronic device.
[FIG. 1D]

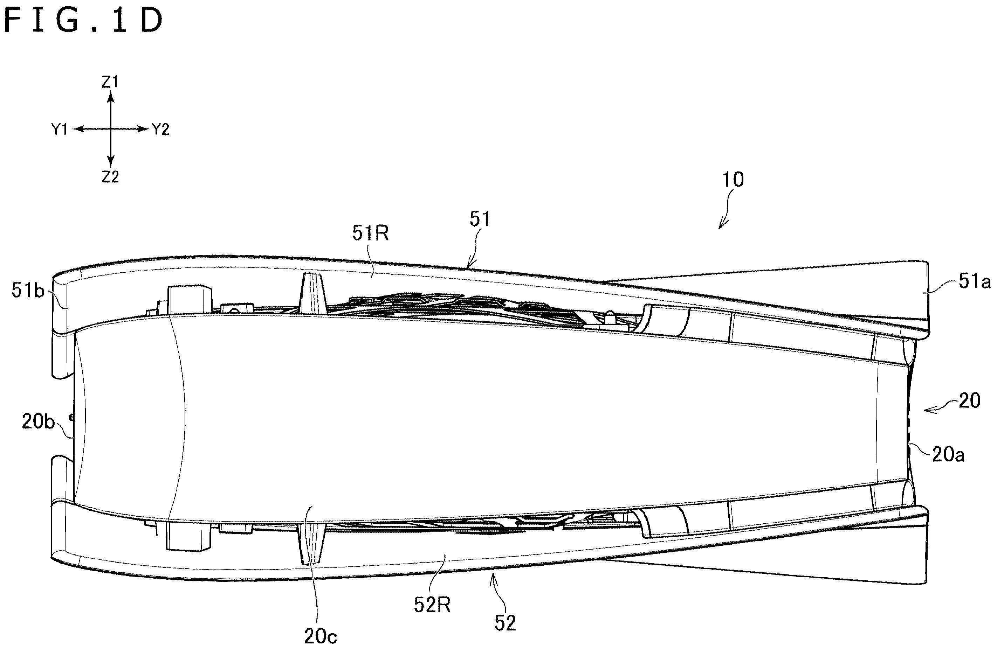

   FIG. 1D is a right side view of the electronic device.
[FIG. 1E]

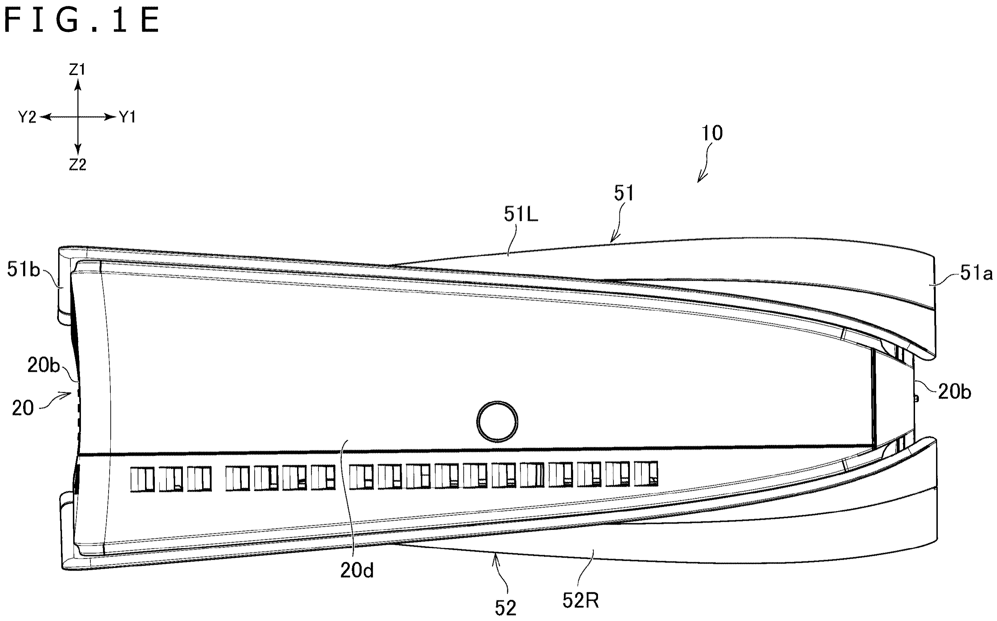

   FIG. 1E is a left side view of the electronic device.
[FIG. 1F]

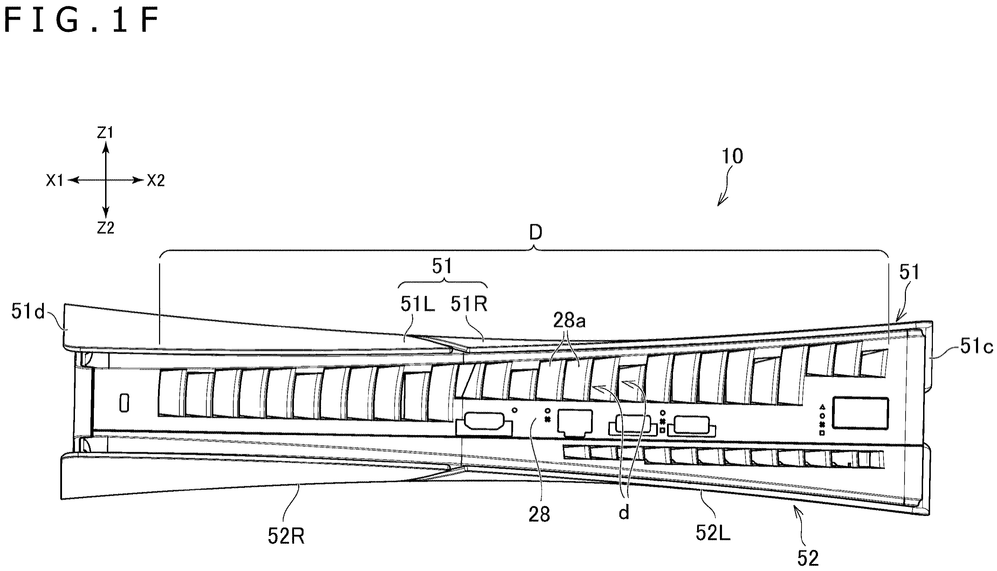

   FIG. 1F is a back view of the electronic device.
[FIG. 1G]

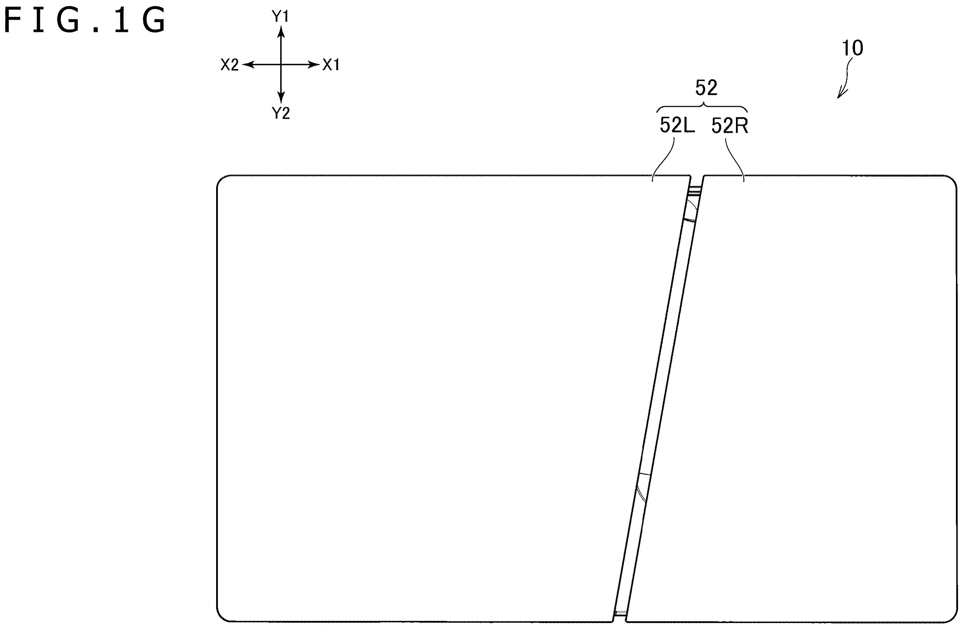

   FIG. 1G is a bottom view of the electronic device.
[FIG. 2A]

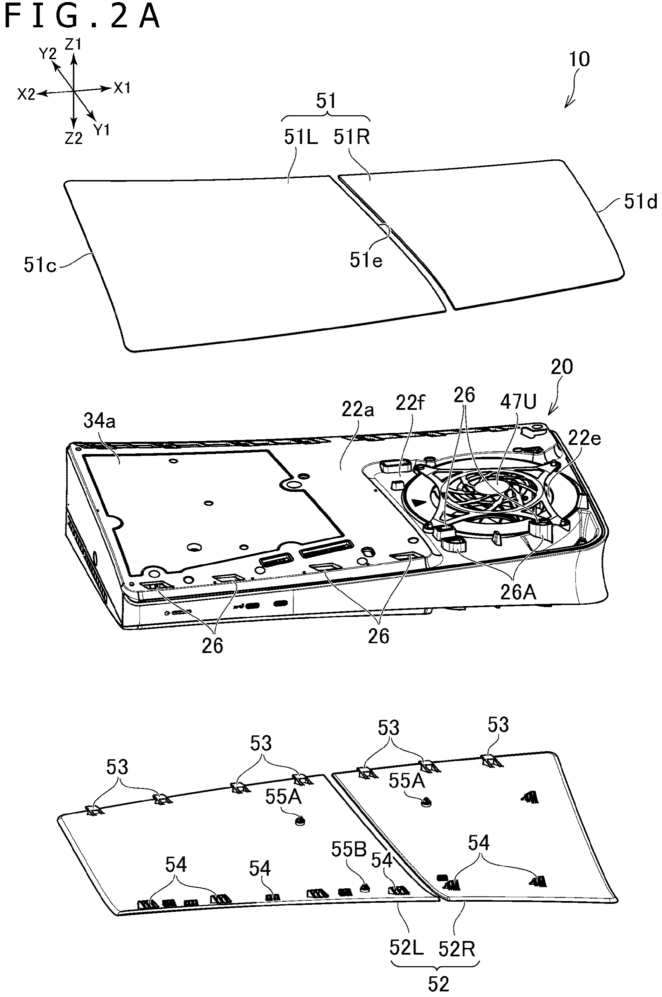

   FIG. 2A is an exploded perspective view of the electronic device, depicting the upper sides of a device body, an upper exterior panel, and a lower exterior panel.
[FIG. 2B]

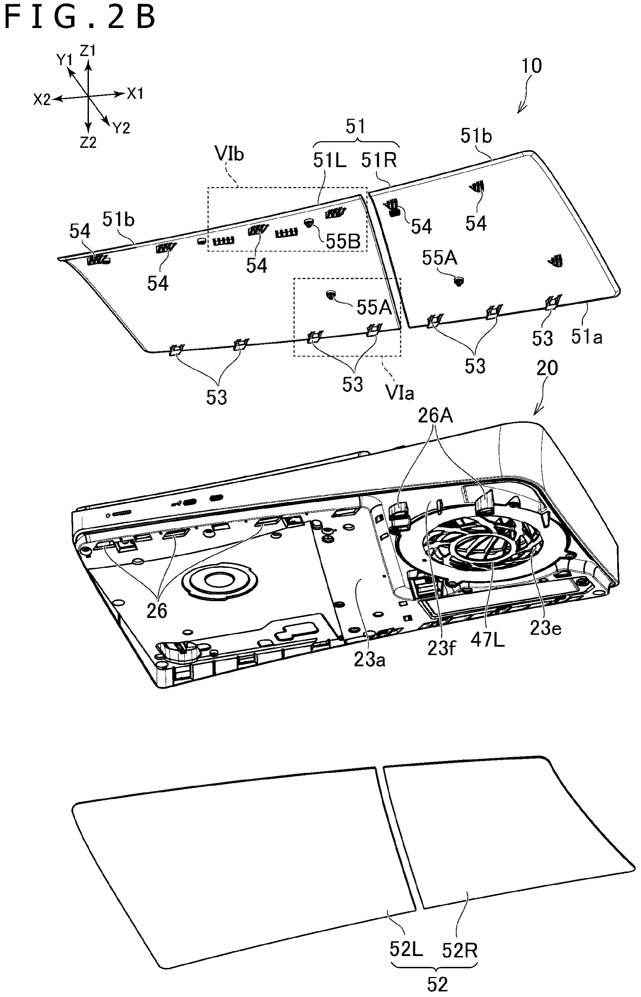

   FIG. 2B is another exploded perspective view of the electronic device, depicting the undersides of the device body, the upper exterior panel, and the lower exterior panel.
[FIG. 3A]

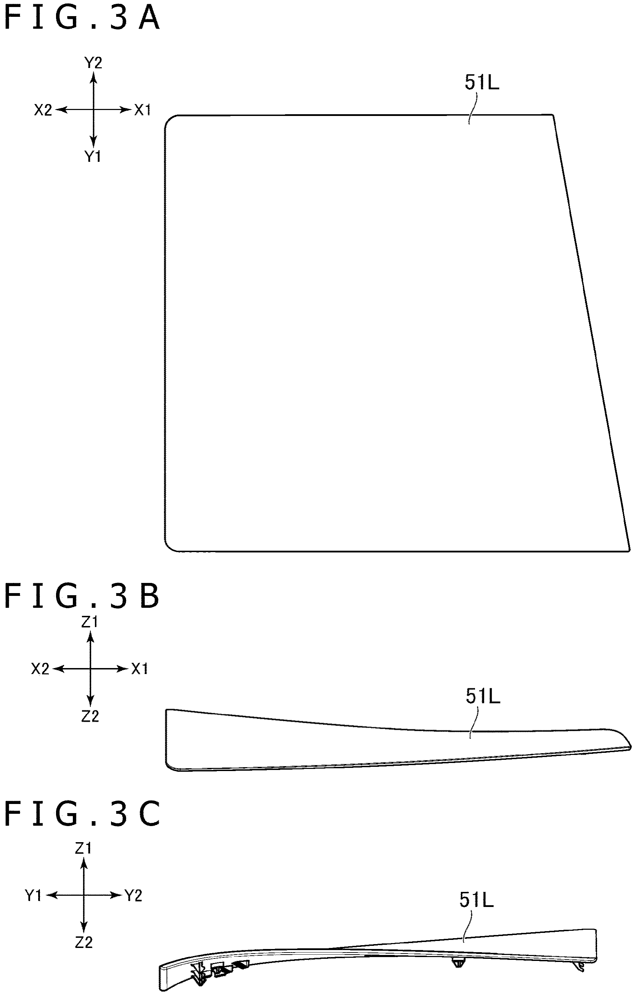

   FIG. 3A is a plan view of a left partial panel of the upper exterior panel.
[FIG. 3B]
   FIG. 3B is a front view of the left partial panel of the upper exterior panel.
[FIG. 3C]
   FIG. 3C is a right view of the left partial panel of the upper exterior panel.
[FIG. 3D]

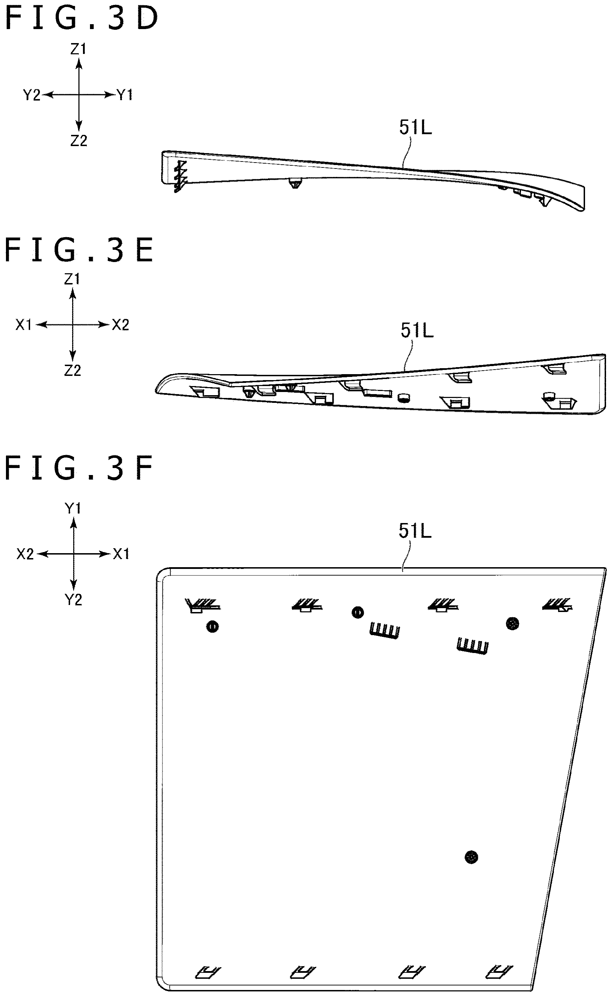

   FIG. 3D is a left view of the left partial panel of the upper exterior panel.
[FIG. 3E]
   FIG. 3E is a back view of the left partial panel of the upper exterior panel.
[FIG. 3F]
   FIG. 3F is a bottom view of the left partial panel of the upper exterior panel.
[FIG. 4]

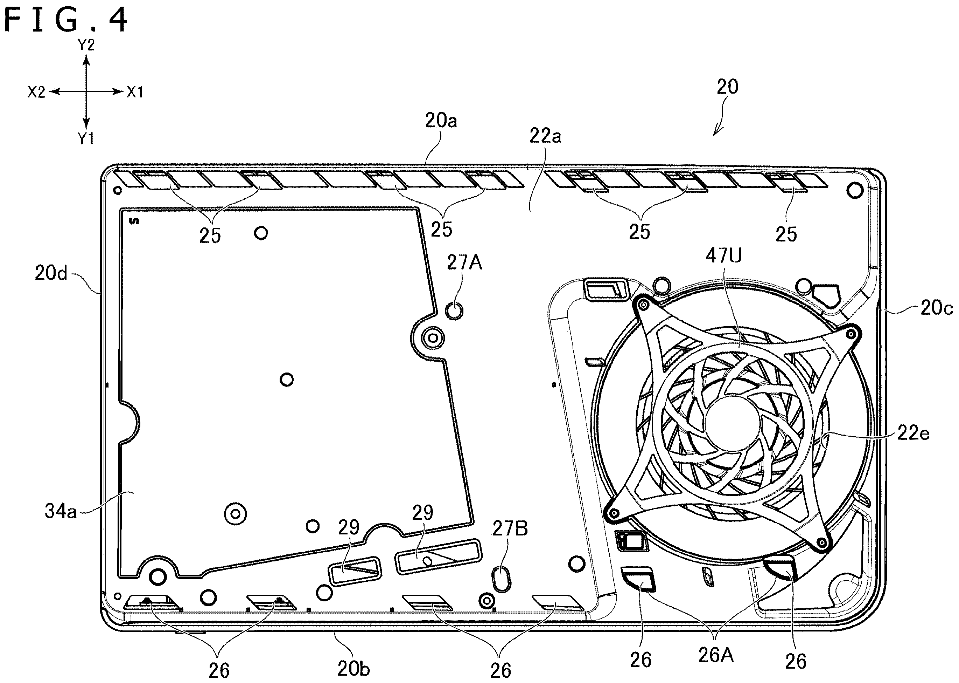

   FIG. 4 is a plan view of the device body.
[FIG. 5]

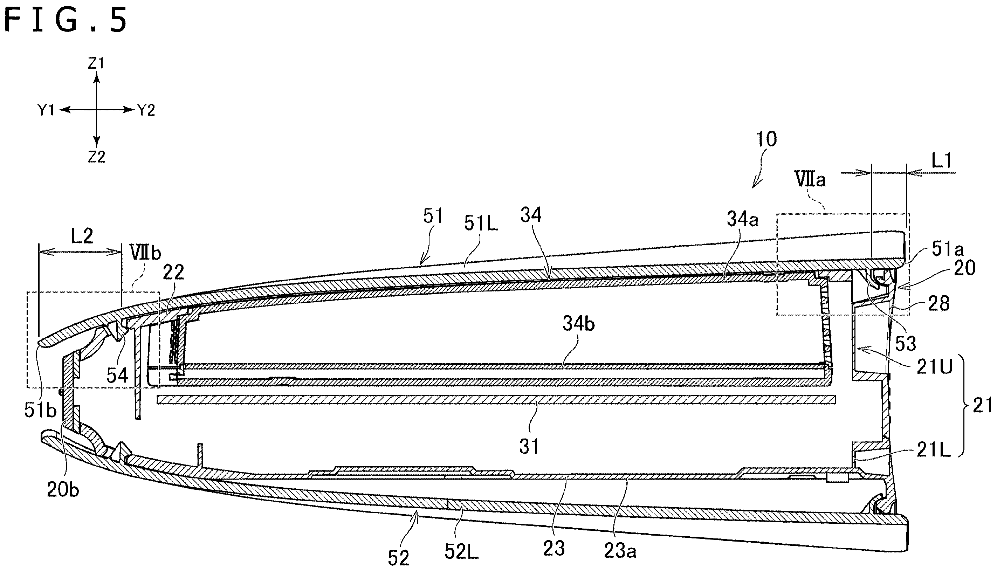

   FIG. 5 is a cross-sectional view taken on line V-V depicted in FIG. 1B.
[FIG. 6A]

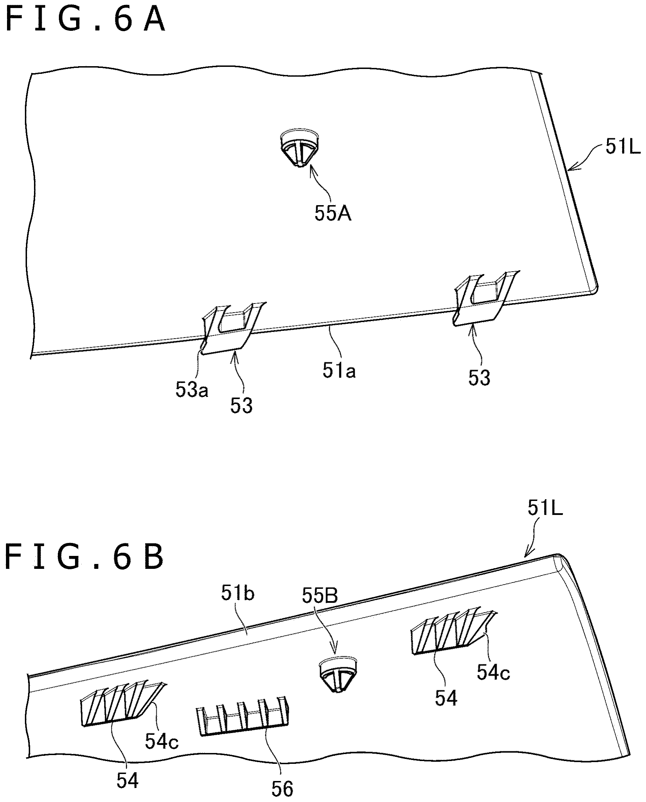

   FIG. 6A is an enlarged view of a region VIa depicted in FIG. 2B.
[FIG. 6B]
   FIG. 6B is an enlarged view of a region VIb depicted in FIG. 2B.
[FIG. 7A]

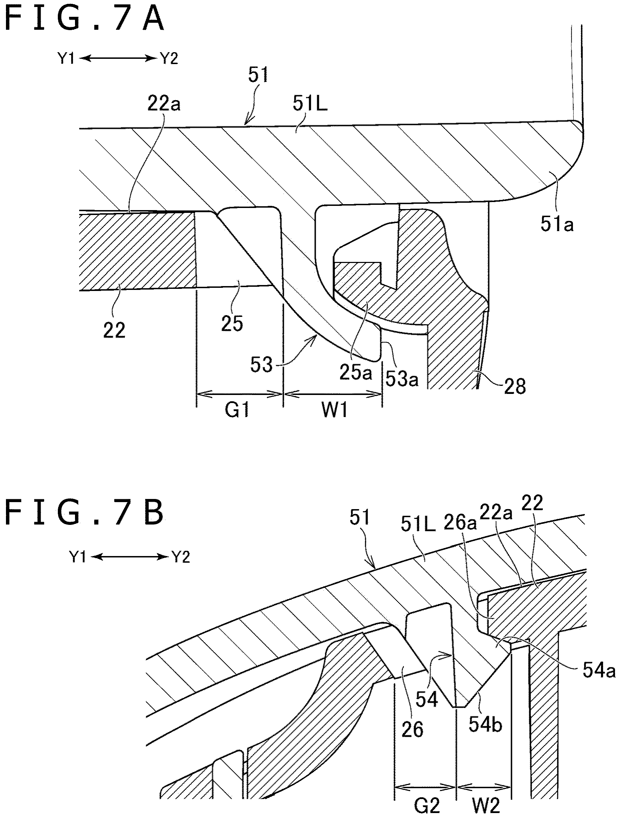

   FIG. 7A is an enlarged view of a region VIIa depicted in FIG. 5.
[FIG. 7B]
   FIG. 7B is an enlarged view of a region VIIb depicted in FIG. 5.
[FIG. 8]

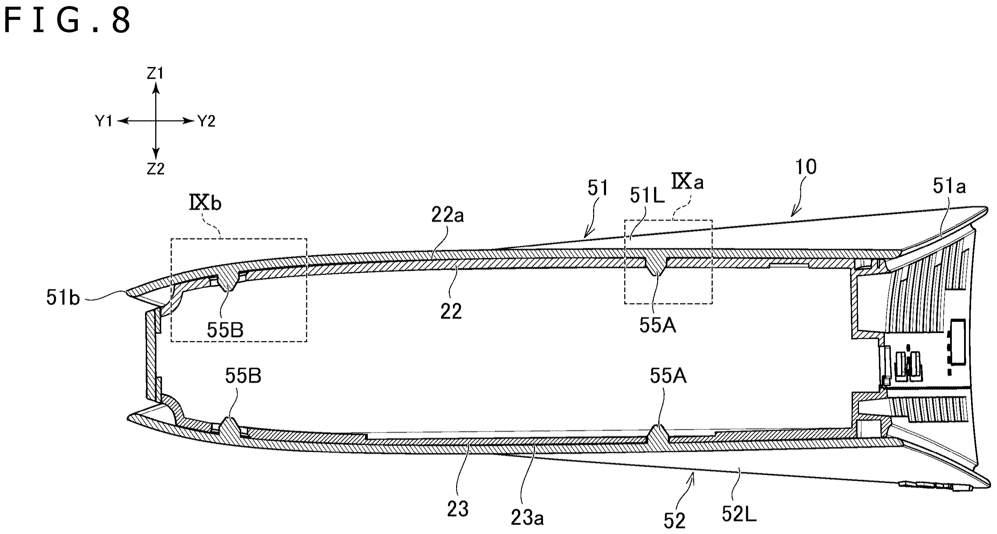

   FIG. 8 is a cross-sectional view taken on line VIII-VIII depicted in FIG. 1B.
[FIG. 9A]

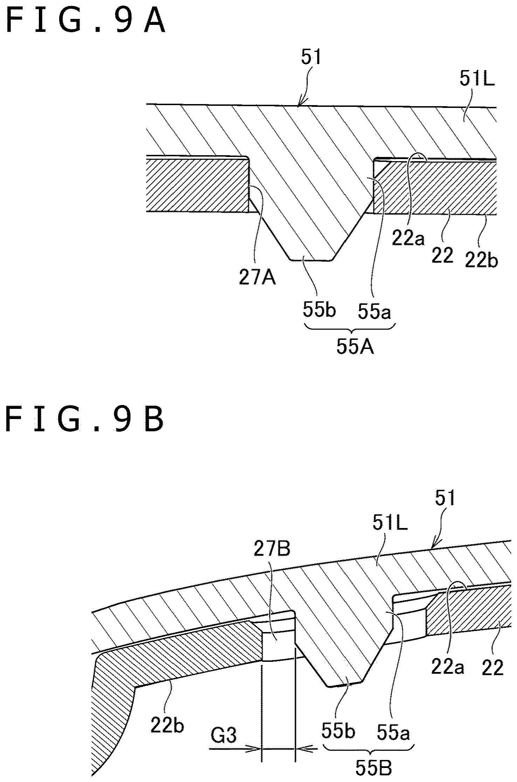

   FIG. 9A is an enlarged view of a region IXa depicted in FIG. 8.
[FIG. 9B]
   FIG. 9B is another enlarged view of the region IXa depicted in FIG. 8.
[FIG. 10]

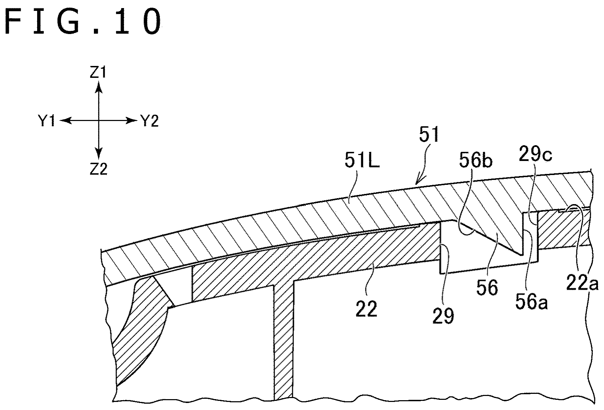

   FIG. 10 is a cross-sectional view taken on line X-X depicted in FIG. 1B.
[FIG. 11]

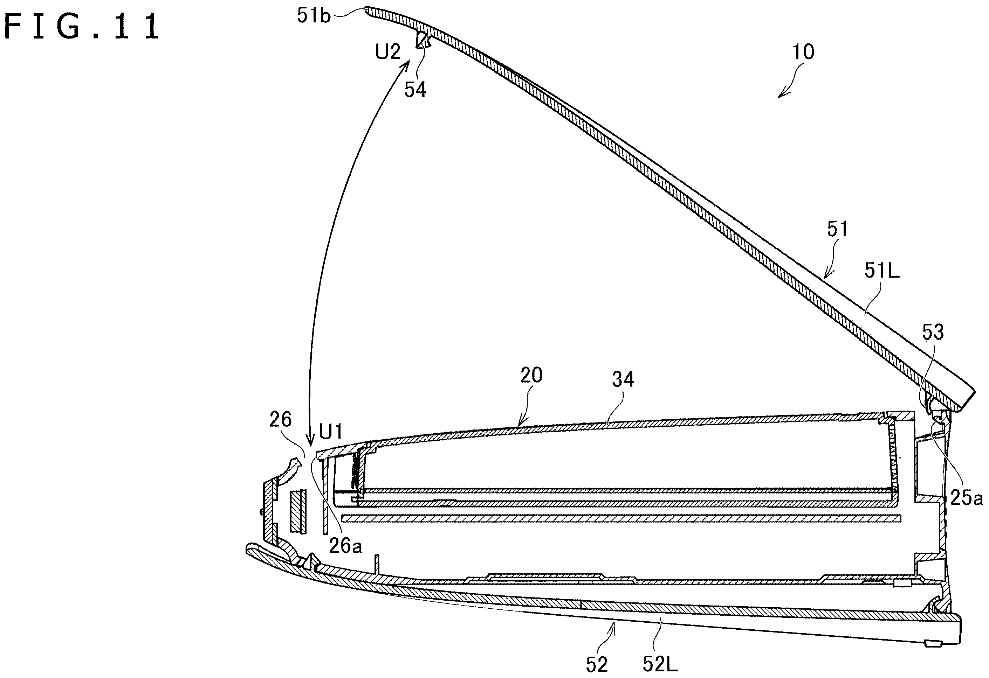

   FIG. 11 is a cross-sectional view explaining a process of attaching the exterior panel.
[FIG. 12]

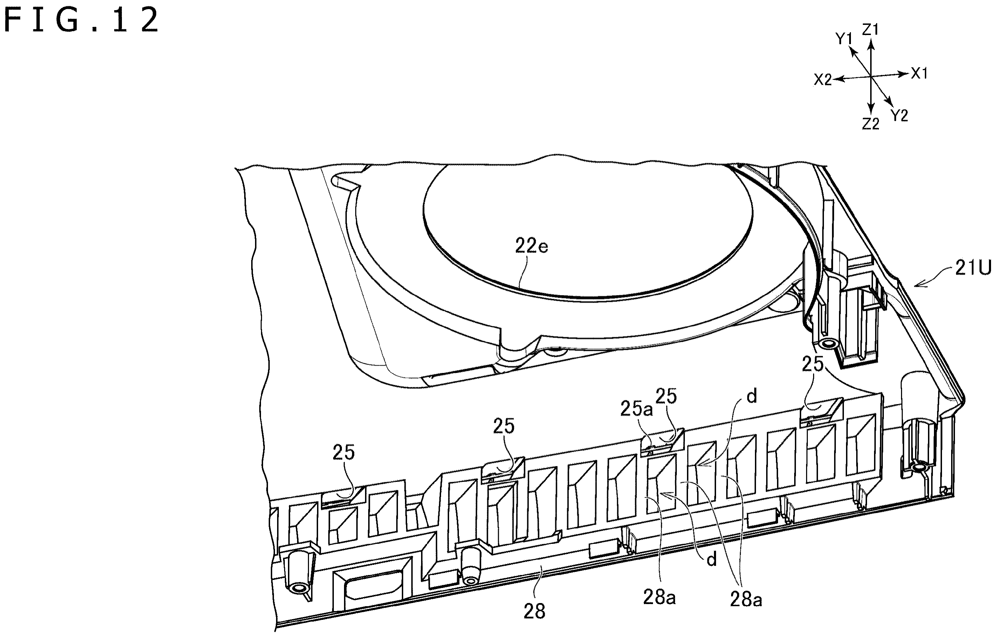

   FIG. 12 is a perspective view depicting an inner surface of an upper housing.
[FIG. 13A]

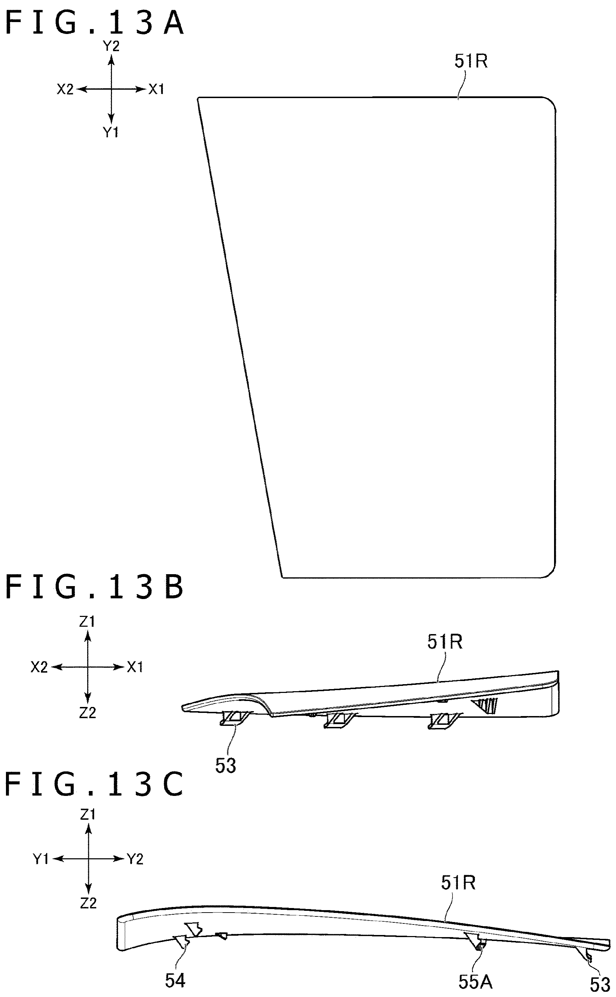

   FIG. 13A is a plan view of a right partial panel of the upper exterior panel.
[FIG. 13B]
   FIG. 13B is a front view of the right partial panel of the upper exterior panel.
[FIG. 13C]
   FIG. 13C is a right side view of the right partial panel of the upper exterior panel.
[FIG. 13D]

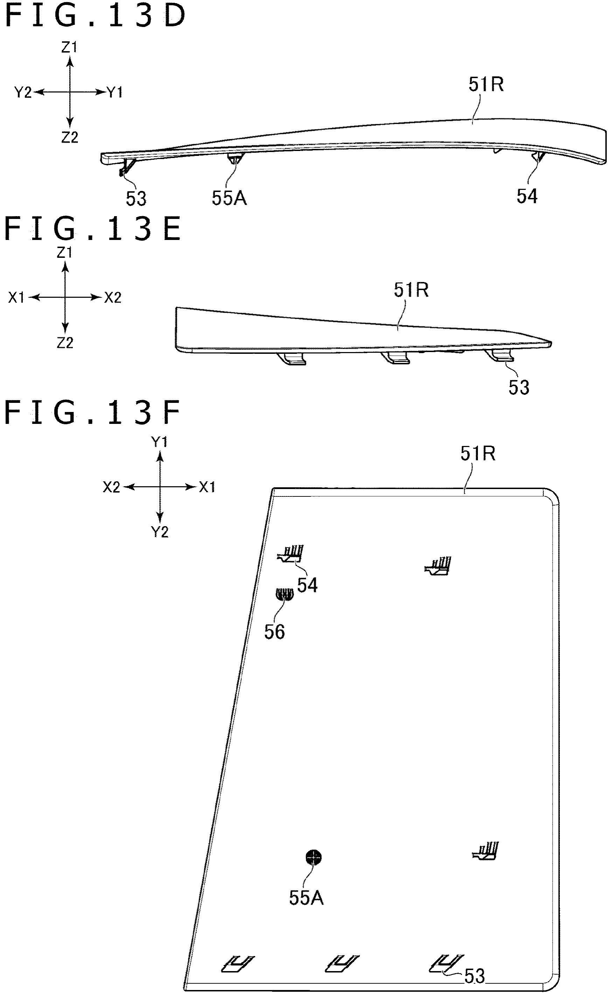

   FIG. 13D is a left side view of the right partial panel of the upper exterior panel.
[FIG. 13E]
   FIG. 13E is a back view of the right partial panel of the upper exterior panel.
[FIG. 13F]
   FIG. 13F is a bottom view of the right partial panel of the upper exterior panel.
[FIG. 14A]

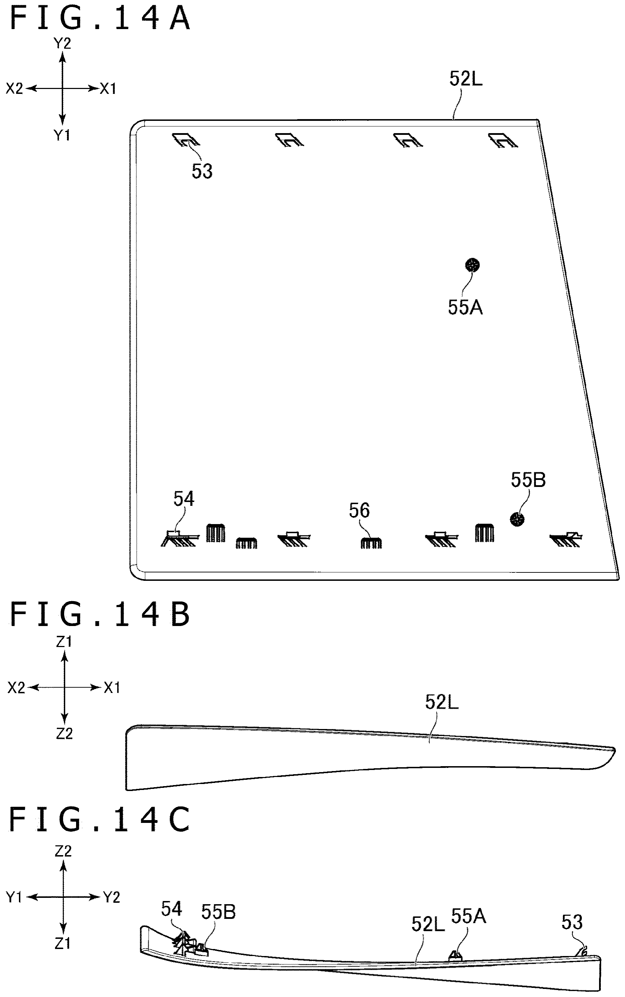

   FIG. 14A is a plan view of a left partial panel of the lower exterior panel.
[FIG. 14B]
   FIG. 14B is a front view of the left partial panel of the lower exterior panel.
[FIG. 14C]
   FIG. 14C is a right side view of the left partial panel of the lower exterior panel.
[FIG. 14D]

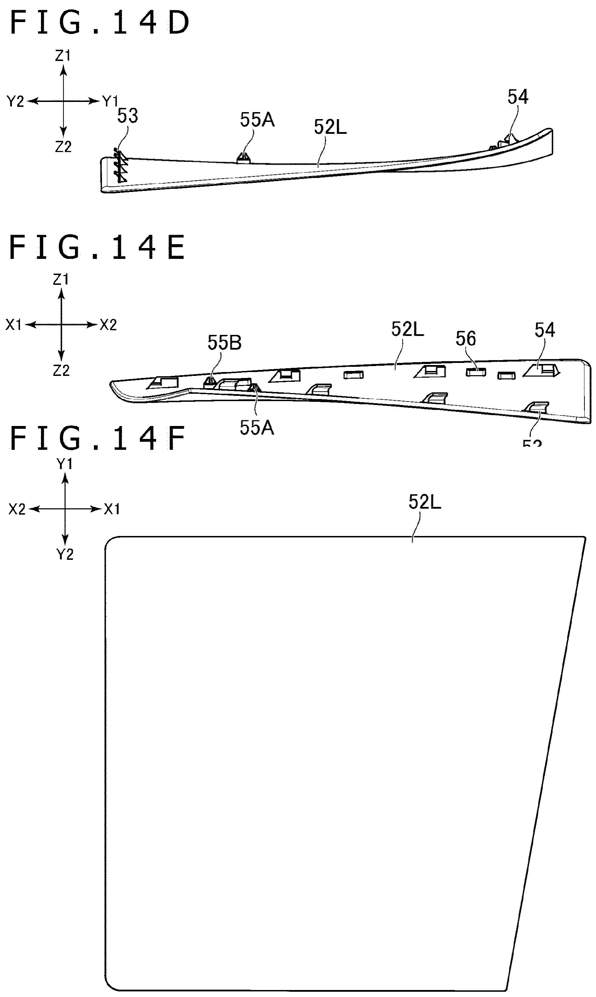

   FIG. 14D is a left side view of the left partial panel of the lower exterior panel.
[FIG. 14E]
   FIG. 14E is a back view of the left partial panel of the lower exterior panel.
[FIG. 14F]
   FIG. 14F is a bottom view of the left partial panel of the lower exterior panel.
[FIG. 15A]

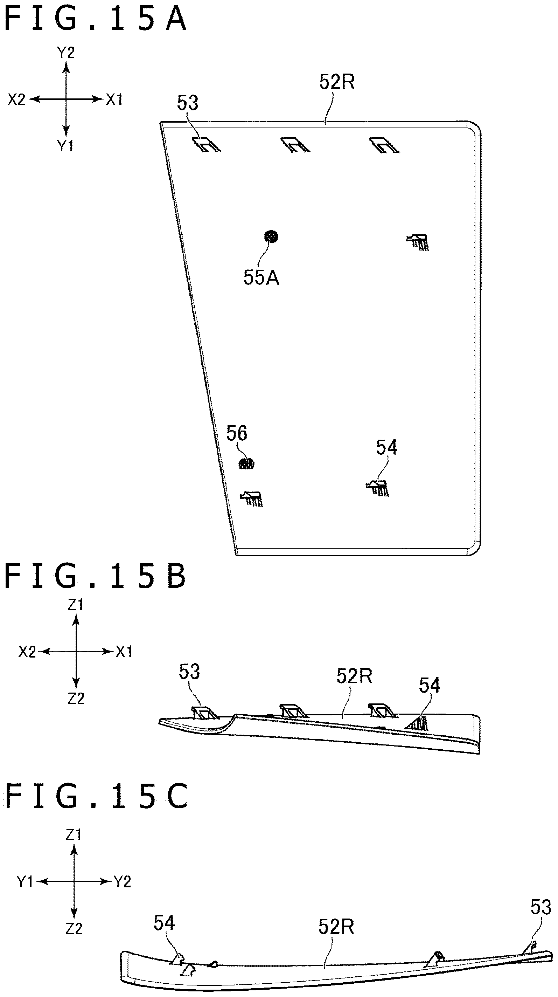

   FIG. 15A is a plan view of a right partial panel of the lower exterior panel.
[FIG. 15B]
   FIG. 15B is a front view of the right partial panel of the lower exterior panel.
[FIG. 15C]
   FIG. 15C is a right side view of the right partial panel of the lower exterior panel.
[FIG. 15D]

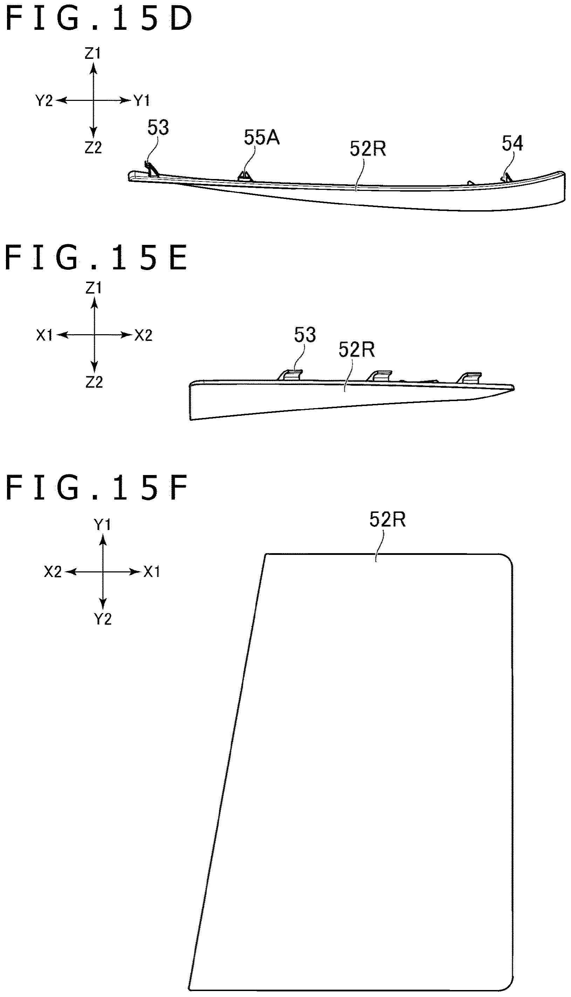

   FIG. 15D is a left side view of the right partial panel of the lower exterior panel.
[FIG. 15E]
   FIG. 15E is a back view of the right partial panel of the lower exterior panel.
[FIG. 15F]
   FIG. 15F is a bottom view of the right partial panel of the lower exterior panel.
[FIG. 16A]

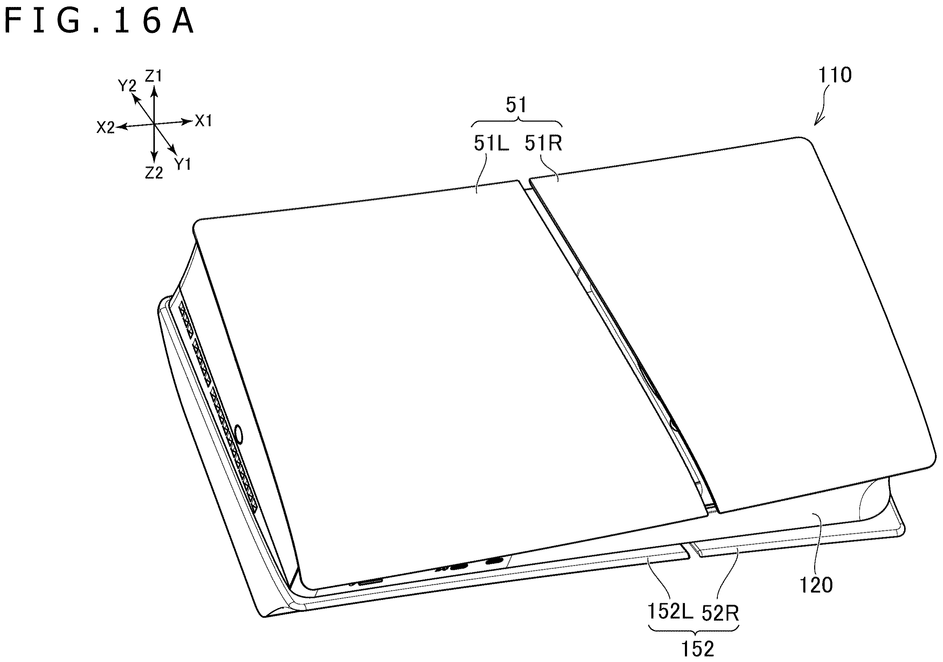

   FIG. 16A is a perspective view depicting another exemplary electronic device proposed according to the present disclosure.
[FIG. 16B]

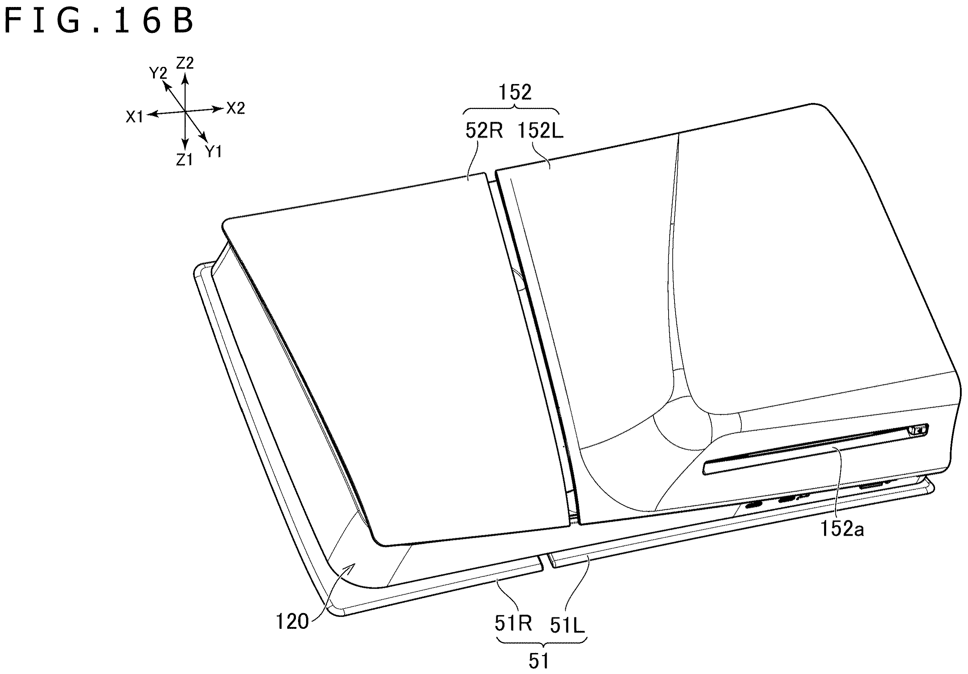

   FIG. 16B is a perspective view depicting the underside of the electronic device depicted in FIG. 16A.
[FIG. 16C]

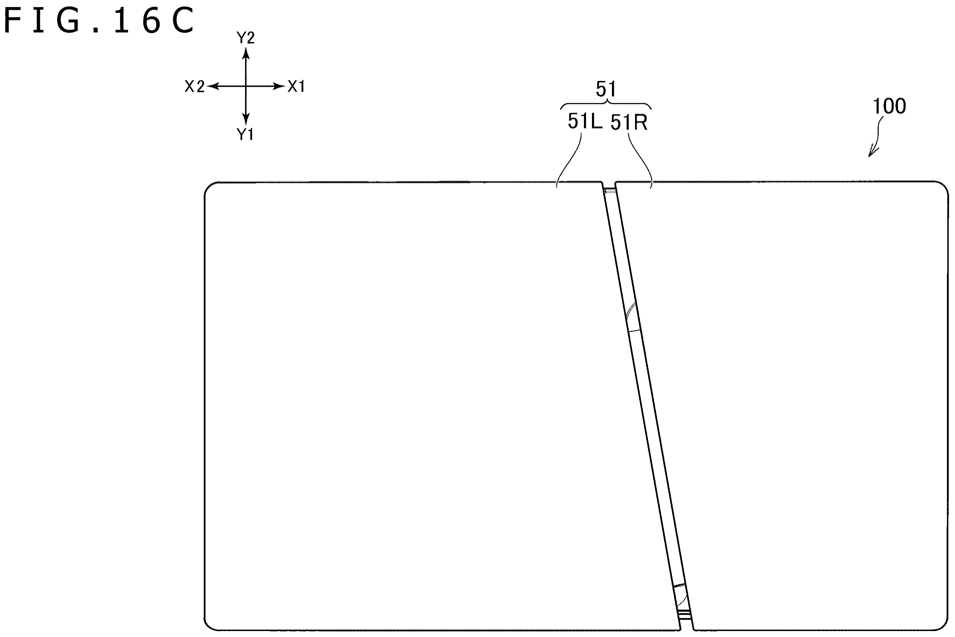

   FIG. 16C is a plan view of the electronic device depicted in FIG. 16A.
[FIG. 16D]

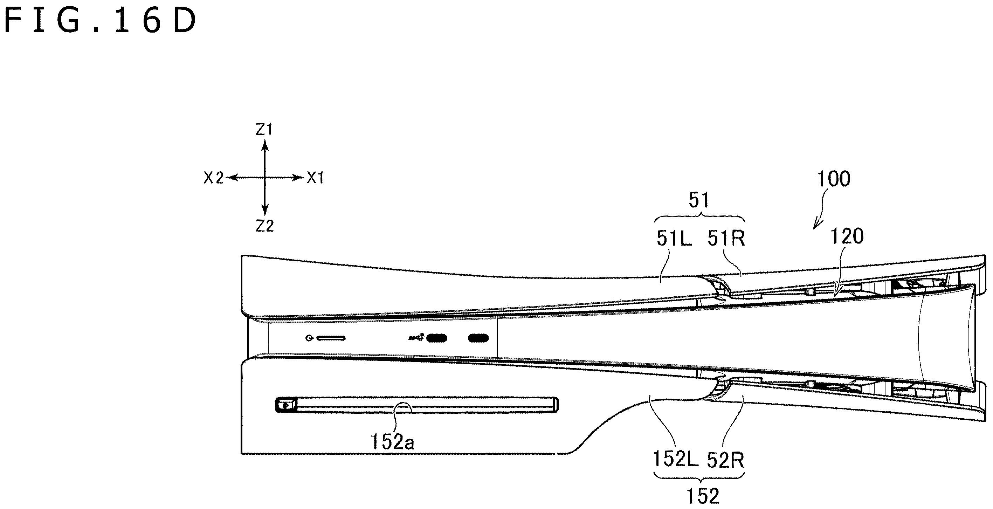

   FIG. 16D is a front view of the electronic device depicted in FIG. 16A.
[FIG. 16E]

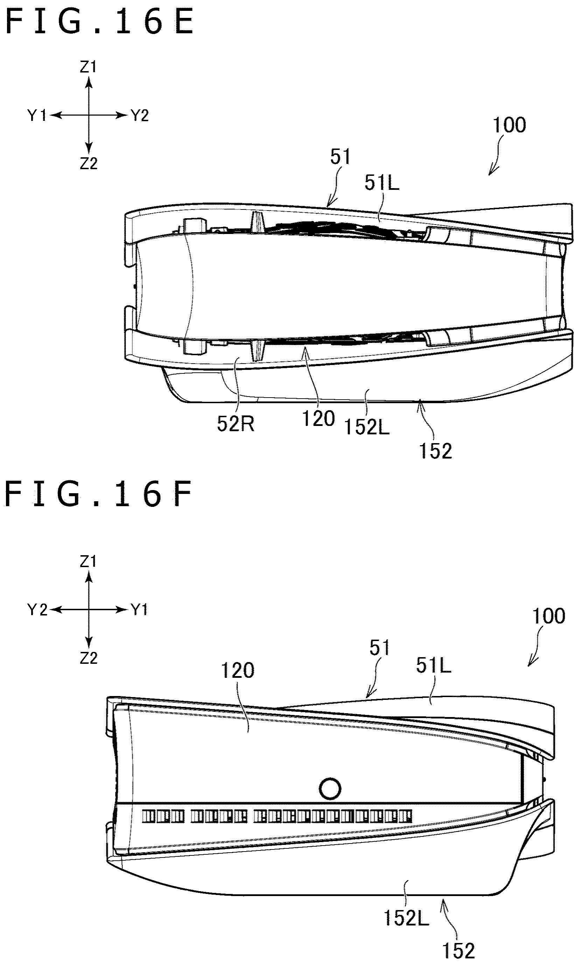

   FIG. 16E is a right side view of the electronic device depicted in FIG. 16A.
[FIG. 16F]
   FIG. 16F is a left side view of the electronic device depicted in FIG. 16A.
[FIG. 16G]

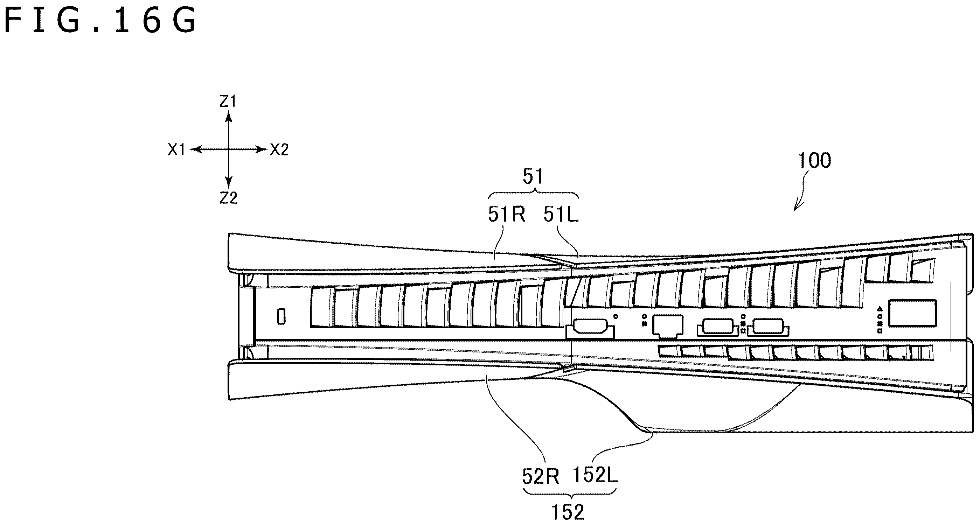

   FIG. 16G is a back view of the electronic device depicted in FIG. 16A.
[FIG. 16H]

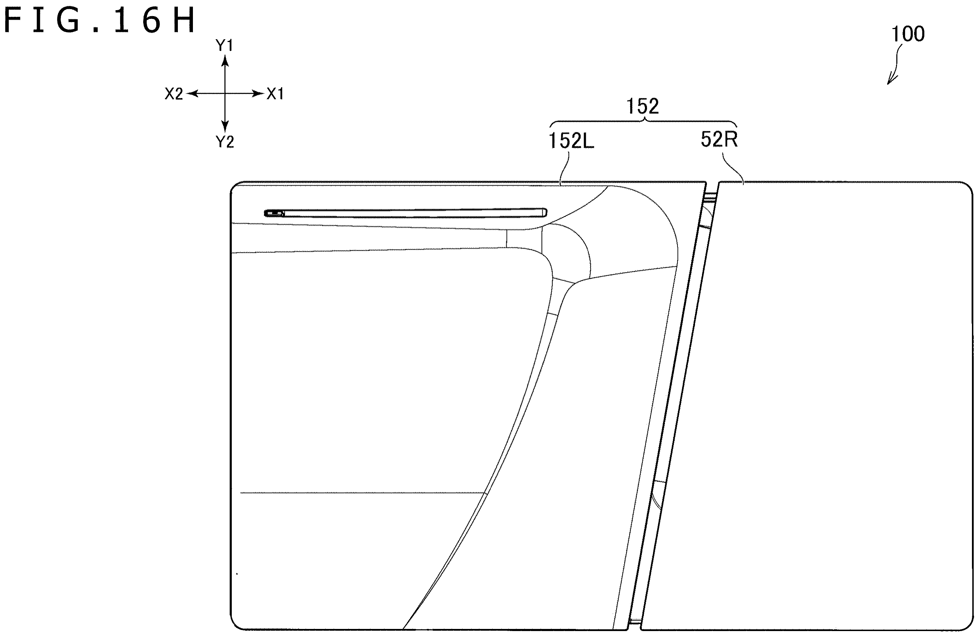

   FIG. 16H is a bottom view of the electronic device depicted in FIG. 16A.
[FIG. 17A]

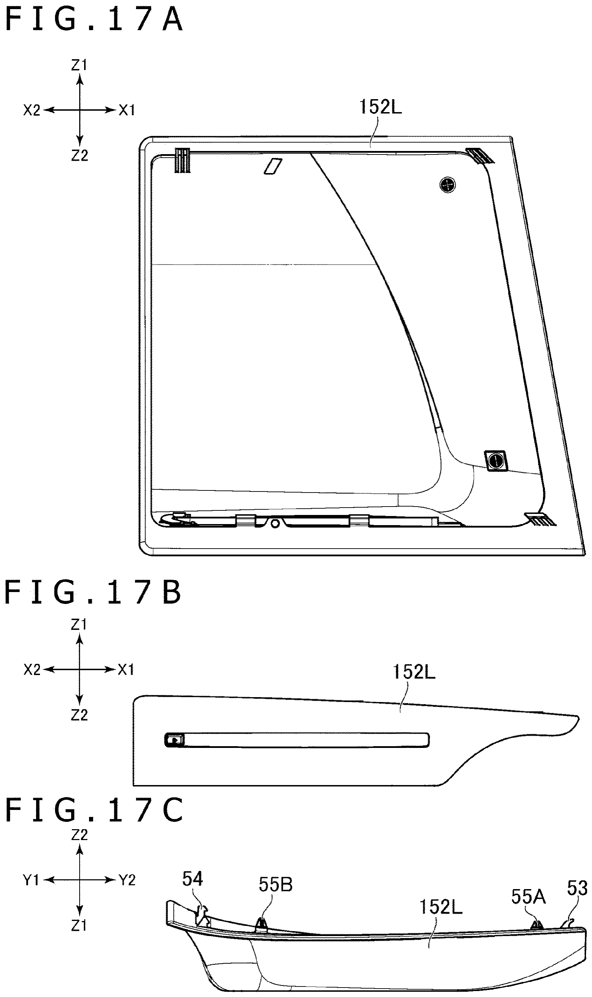

   FIG. 17A is a plan view of a left partial panel constituting a lower exterior panel of the electronic device depicted in FIG. 16A.
[FIG. 17B]
   FIG. 17B is a front view of the left partial panel depicted in FIG. 17A.
[FIG. 17C]
   FIG. 17C is a right side view of the left partial panel depicted in FIG. 17A.
[FIG. 17D]

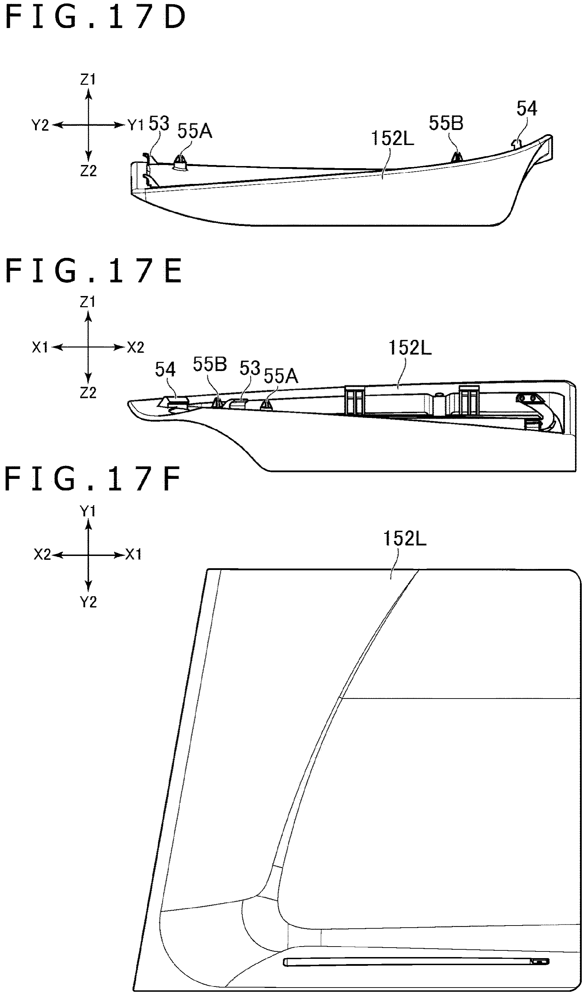

   FIG. 17D is a left side view of the left partial panel depicted in FIG. 17A.
[FIG. 17E]
   FIG. 17E is a back view of the left partial panel depicted in FIG. 17A.
[FIG. 17F]
   FIG. 17F is a bottom view of the left partial panel depicted in FIG. 17A.

### [Description of Embodiments]

The electronic device proposed according to the present disclosure is described below with reference to the accompanying drawings. This disclosure explains an electronic device 10 as one example of the proposed device.

In the description that follows, directions Z1 and X2 indicated in FIG. 1A and other drawings will be referred to as the upper side and the underside, respectively. Also, directions X1 and X2 in the drawings will be referred to as the right side and the left side, respectively, and directions Y1 and Y2 in the drawings will be referred to as the front side and the back side, respectively. These directions are defined so as to explain the shapes of the constituent elements (components, members, and parts) of the electronic device 10 as well as the positional relations between these elements. Thus, the directions in the drawings do not limit the posture of the electronic device 10 in use.

### [Electronic device]

The electronic device 10 is an entertainment apparatus that functions as a game apparatus or an audio-visual device, for example. The electronic device 10 outputs moving image data generated by execution of game programs, video and audio data acquired via networks, and video and audio data retrieved from recording media such as optical disks to a display apparatus such as a TV set. The electronic device may also be a personal computer or a server computer.

As depicted in FIG. 2A, the electronic device 10 has a device body 20, an upper exterior panel 51 covering an upper surface 22a of the device body 20, and a lower exterior panel 52 covering a lower surface 23a (see FIG. 2B) of the device body 20.

The exterior panels 51 and 52 may be curved in whole. For example, the upper exterior panel 51 may be curved in a manner being recessed downward on a cut surface along one of its two diagonal lines and protruding upward on a cut surface along the other diagonal line. The lower exterior panel 52 may be shaped to be symmetrical with respect to the upper exterior panel 51 across a horizontal plane (i.e., plane along a circuit board 51, to be discussed later). The curved shapes of the exterior panels 51 and 52 are not limited to those explained here. Unlike in the example described above, the exterior panels 51 and 52 may be in parallel with the horizontal plane.

As depicted in FIG. 5, the device body 20 has a housing 21. The housing 21 houses the circuit board 31, for example. The circuit board 31 may be arranged in parallel with the front-back direction (Y1-Y2 direction) and right-left direction (X1-X2 direction). The circuit board 31 is mounted with various electronic components such as a central processing unit (CPU), a graphical processing unit (GPU), and a memory. The housing 21 may also house a power supply apparatus 34. Supplied with power from outside the electronic device 10, the power supply apparatus 34 feeds drive power to the apparatuses (e.g., circuit board 31) inside the device body 20. The power supply apparatus 34 has a case 34a and a circuit board 34b arranged inside the case 34a.

As depicted in FIG. 5, the housing 21 may have an upper housing 21U and a lower housing 21L coupled with each other in the up-down direction, for example. The upper housing 21U covers the upper sides of various apparatuses inside the device body 20 (e.g., circuit board 31). The upper housing 21U has an upper wall 22 constituting the upper surface 22a of the device body 20. As illustrated in FIG. 5, the upper surface of the case 34a of the power supply apparatus 34 may be exposed upward from an opening formed in the upper wall 22. The lower housing 21L covers the undersides of various apparatuses inside the device body 20 (e.g., circuit board 31). The lower housing 21L has a lower wall 23 constituting the lower surface 23a of the device body 20.

As depicted in FIGS. 2A and 2B, air intake ports 22e and 23e are formed in the housing 21. The air intake ports 22e and 23e are located in the upper surface 22a and on the lower surface 23a of the device body 20, respectively. That is, the air intake ports 22e and 23e are formed in the above-mentioned upper wall 22 and lower wall 23, respectively. Edges of the air intake ports 22e and 23e may be equipped with covers 47U and 47L which cover the air intake ports 22e and 23e and in which multiple openings are made.

The housing 21 houses a cooling fan (not depicted) for introducing outside air into the housing 21 through the air intake ports 22e and 23e. The cooling fan is interposed between the upper and lower air intake ports 22e and 23e, for example, and arranged to be rotatable around an axis line along the up-down direction. The housing 21 also houses radiators (heat sink, heat pipe, etc.). The radiators are thermally connected to the electronic components such as the CPU mounted on the circuit board 31. The cooling fan produces an airflow that passes by the radiators inside the housing 21.

### [Exterior panels]

As depicted in FIG. 2A, the upper exterior panel 51 may have partial panels 51R and 51L juxtaposed in the right-left direction. The right partial panel 51R and the left partial panel 51L cover the right side and left side of the upper surface 22a of the device body 20, respectively. As illustrated in FIG. 2B, the lower exterior panel 52 may also have partial panels 52R and 52L juxtaposed in the right-left direction. The right partial panel 52R and the left partial panel 52L cover the right side and left side of the lower surface 23a of the device body 20, respectively.

The exterior panels 51 and 52 may cover the air intake ports 22e and 23e formed in the upper surface 22a (see FIG. 2A) and the lower surface 23a (see FIG. 2B) of the device body 20, respectively. A gap that serves as an airflow path may be formed between the upper exterior panel 51 and the upper surface 22a of the device body 20. Likewise, a gap that functions as an airflow path may be formed between the lower exterior panel 52 and the lower surface 23a of the device body 20.

In the examples depicted in FIGS. 2A and 2B, the right partial panels 51R and 52R of the upper and lower exterior panels 51 and 52 cover the air intake ports 22e and 23e, respectively. A gap that serves as an airflow path is formed between the upper right partial panel 51R and the upper surface 22a. A gap that functions as an airflow path is also formed between the lower right partial panel 52R and the lower surface 23a.

As depicted in FIG. 1C, air intake ports Sa and Sb are formed between an outer peripheral edge of the exterior panels 51 and 52 and an outer peripheral edge of the device body 20. More specifically, the air intake ports Sa and Sb are formed between a front edge and a right edge of the upper right partial panel 51R on one hand, and an edge of the upper surface 22a of the device body 20 on the other hand. Likewise, air intake ports Sc and Sd are formed between a front edge and a right edge of the lower right partial panel 52R on one hand, and an edge of the lower surface 23a of the device body 20 on the other hand.

As depicted in FIG. 1C, outside air is introduced into the airflow path between the upper exterior panel 51 and the upper surface 22a of the device body 20 through the air intake ports Sa and Sb formed on the upper side of the device body 20. The air thus introduced is directed toward the air intake port 22e formed in the upper surface 22a of the device body 20. Outside air is also introduced into the airflow path between the lower exterior panel 52 and the lower surface 23a of the device body 20 through the air intake ports Sc and Sd formed on the underside of the device body 20. The introduced air is then directed toward the air intake port 23e formed in the lower surface 23a of the device body 20.

Note that the structures of the exterior members of the electronic device 10 are not limited to the examples illustrated in the drawings.

As another example, in the electronic device 10, the air intake ports Sa through Sd formed between the exterior panels 51 and 52 on one hand and an outer peripheral edge of the device body 20 on the other hand may be replaced by air intake ports formed in a front surface 20b of the device body 20 or in right and left side surfaces 20c and 20d thereof. A power button and connectors may be provided on the front surface 20b.

As a further example, the air intake ports Sa and Sb opened toward the upper side (above the upper exterior panel 51) of the electronic device 10 may be replaced by, or supplemented with, air intake ports formed in the upper exterior panel 51. Also, the air intake ports Sc and Sd opened toward the underside (under the lower exterior panel 52) of the electronic device 10 may be replaced by, or supplemented with, air intake ports formed in the lower exterior panel 52.

As an even further example, either of the air intake ports Sa and Sb positioned on the upper side of the electronic device 10 or the air intake ports Sc and Sd positioned on the underside thereof, may be eliminated.

### [Structure for attaching the exterior panels]

The structure for attaching the exterior panels 51 and 52 to the device body 20 is explained below. As discussed above, the exterior panels 51 and 52 are equipped with the right partial panels 51R and 52R and the left partial panels 52L and 52L. The right partial panel 51R and the left partial panel 51L of the upper exterior panel 51 are not connected with each other, such that each of them may be detached independently from the device body 20. That is, only the right partial panel 51R or the left partial panel 51L alone may be detached from the device body 20. Likewise, the right partial panel 52R and the left partial panel 52L of the lower exterior panel 52 are not connected with each other, so that each of them may be detached independently from the device body 20. As depicted in FIG. 2A, a gap may be formed between the left partial panels 51L and 52L on one hand and the right partial panels 51R and 52R on the other hand.

Since the structure for attaching the partial panels 51R, 51L, 52R, and 52L is substantially the same, the attachment structure is explained below mainly with reference to the left partial panel 51L of the upper exterior panel 51.

Note that the exterior panels 51 and 52 may not be equipped with the partial panels 51R, 51L, 52R, and 52L. That is, the exterior panels 51 and 52 may each be configured by a single panel. In this case, the structure of the partial panel 51L to be explained below may be applied to the entire upper exterior panel 51. The same structure may also be applied to the entire lower exterior panel 52.

### [Engaging parts and engaged parts]

As depicted in FIG. 2B, the partial panel 51L has a back edge 51a and a front edge 51b. The back edge 51a and the front edge 51b are positioned opposite to each other in the front-back direction. The front edge 51b may protrude forward beyond the position of the front surface 20b of the device body 20 (see FIG. 1D). Likewise, the back edge 51a may protrude backward beyond the position of a back surface 20a of the device body 20 (see FIG. 1D).

As depicted in FIG. 2B, the partial panel 51L is equipped with a back engaging part 53 and a front engaging part 54. The back engaging part 53 is positioned behind a center of the partial panel 51L along the front-back direction. The front engaging part 54 is positioned in front of the center of the partial panel 51L along the front-back direction. For example, the back engaging part 53 may be formed along the back edge 51a, and the front engaging part 54 may be formed along the front edge 51b. Between the back engaging part 53 and the front engaging part 54, the partial panel 51L has no other engaging part that would engage with the upper surface 22a of the device body 20.

As depicted in FIG. 2B, the partial panel 51L has multiple back engaging parts 53, which may be aligned in the right-left direction. The partial panel 51L also has multiple front engaging parts 54, which may be aligned in the right-left direction.

As depicted in FIG. 6A, the back engaging part 53 may be a protruding part protruding from the lower surface of the partial panel 51L toward the device body 20. As illustrated in FIG. 6B, the front engaging part 54 may be a protruding part protruding from the lower surface of the partial panel 51L toward the device body 20, for example. The front engaging part 54 protrudes from the lower surface of the partial panel 51L in a direction substantially perpendicular to a horizontal plane in the front-back and right-left directions.

As depicted in FIGS. 4 and 7A, a back engaged part 25a configured to be engaged with the back engaging part 53 is formed on the upper surface 22a (upper wall 22) of the device body 20. Here, the wording "the back engaging part 53 engages with the back engaged part 25a" means that the two parts are fitted with each other in such a manner that the engaged part 25a restrains the back engaging part 53 from getting separated upward.

As depicted in FIG. 7A, a hole 25 configured to be fitted with the back engaging part 53 of the partial panel 51L is formed in the upper surface 22a (upper wall 22) of the device body 20. The back engaged part 25a is formed on an edge of the hole 25. The back engaged part 25a is in contact with the back engaging part 53 not on a whole inner edge but a portion thereof of the hole 25 and restrains the back engaging part 53 from getting separated upward.

Also, as depicted in FIGS. 4 and 7B, a front engaged part 26a configured to be engaged with the front engaging part 54 is formed on the upper surface 22a (upper wall 22) of the device body 20. Here, the wording "the front engaging part 54 engages with the front engaged part 26a" means that the two parts are fitted with each other in such a manner that the front engaged part 26a restrains the front engaging part 54 from getting separated upward.

As depicted in FIG. 7B, a hole 26 configured to be fitted with the front engaging part 54 of the partial panel 51L is formed in the upper surface 22a of the device body 20. The front engaged part 26a configured to be engaged with the front engaging part 54 is formed on an edge of the hole 26. Here, the front engaged part 26a is in contact with the front engaging part 54 not on a whole inner edge but a portion thereof of the hole 26 and restrains the front engaging part 54 from getting separated upward.

As depicted in FIG. 11, when the back engaging part 53 of the partial panel 51L engages with the back engaged part 25a and the front engaging part 54 does not engage with the back engaged part 26a, the partial panel 51L is rotatable around the back engaging part 53 in a direction in which the front edge 51b of the partial panel 51L approaches the device body 20 (in an arrowed direction U1 in FIG. 11) and in a direction in which the front edge 51b is separated from the device body 20 (in an arrowed direction U2 in FIG. 11).

As indicated by an arrow U1 in FIG. 11, when the partial panel 51L is rotated to let the front edge 51b approach the device body 20 so as to fit the front engaging part 54 in the hole 26 of the device body 20, the front engaging part 54 engages with the front engaged part 26a. This allows the partial panel 51L to be attached to the device body 20. Conversely, when the partial panel 51L is deformed to bend upward the front part of the partial panel 51L, the front engaging part 54 and the front engaged part 26a are disengaged from each other. When the partial panel 51L is rotated to separate the front edge 51b from the device body 20, the partial panel 51L is detached from the device body 20.

As depicted in FIG. 2A, the upper surface 22a of the device body 20 may have a lower part 22f in which the air intake port 22e is formed and which is covered by the right partial panel 51R. The lower part 22f is lower than the portion covered by the left partial panel 51L on the upper surface 22a. The hole 26 is also formed in the lower part 22f. A tube part 26A protruding upward is formed on the lower part 22f. The inside of the tube part 26A functions as the hole 26. The engaged part 26a (see FIG. 7B) may be formed inside the tube part 26A. The tube part 26A ensures an airflow path between the right partial panel 51R and the upper surface 22a. The same structure may also be formed on the lower surface 23a of the device body 20. That is, as depicted in FIG. 2B, a bottom part 23f may be formed on the lower surface 23a, and the tube part 26A may be formed on the bottom part.

As depicted in FIG. 7A, when the back engaging part 53 engages with the back engaged part 25a, the back engaged part 25a is positioned behind the back engaging part 53. Also, as illustrated in FIG. 7B, when the front engaging part 54 engages with the front engaged part 26a, the front engaged part 26a is positioned behind the front engaging part 54. That is, the engaged parts 25a and 26a are positioned on the same side (back side) with respect to the engaging parts 53 and 54.

Given the positional relation between the engaging parts 53 and 54 on one hand and the engaged parts 25a and 26a on the other hand, it is possible to easily release the engagement between the front engaging part 54 and the front engaged part 26a and the engagement between the back engaging part 53 and the back engaged part 25a. The work of detaching the partial panel 51L can thus be easily facilitated. For example, the front part of the partial panel 51L may be bent to release the engagement between the front engaging part 54 and the front engaged part 26a, before the partial panel 51L may be rotated to separate the front edge 51b from the device body 20. This can naturally release the engagement between the back engaging part 53 and the back engaged part 25a as well.

Note that the partial panel 51L may be formed of a resin, for example, to let the front part thereof bend (warp) in this manner. The partial panel 51L may alternatively be formed of a metal.

As depicted in FIG. 2A, a left edge 51c and a right edge 51e of the partial panel 51L have no side walls. That is, the partial panel 51L has no wall portions descending toward the device body 20 on the left edge 51c and the right edge 51e. The left edge 51c of the partial panel 51L has an end surface facing left, and the right edge 51e of the partial panel 51L has an end surface facing right. This makes it relatively easy to bend the front part of the partial panel 51L as discussed above. Note that, as with the left partial panel 51L, the right partial panel 51R also has no side walls descending toward a right edge 51d and a left edge. That is, the upper exterior panel 51 configured by the two partial panels 51R and 51L has no side walls descending toward the device body 20.

As depicted in FIG. 5, a distance L2 from the front edge 51b of the partial panel 51L to the front engaging part 54 is greater than a distance L1 from the back edge 51a of the partial panel 51L to the back engaging part 53. When detaching the partial panel 51L from the device body 20, the worker bends upward the front part of the partial panel 51L to release the engagement between the front engaging part 54 and the front engaged part 26a. At this point, with the distance L1 relatively long, the front part of the partial panel 51L can be bent with small force. Consequently, the work of detaching the partial panel 51L is made much easier. Note that the front engaging part 54 may be positioned in front of a middle position of the partial panel 51L along the front-back direction.

As depicted in FIG. 5, the back engaged part 25a may be formed on the back end of the upper wall 22, for example. In other words, the back engaged part 25a may be formed on the top end of a back wall 28 (see FIG. 7A) of the housing 21, for example. Forming the back engaged part 25a in this manner makes it easy to position the back engaging part 53 and the back engaged part 25a relative to each other, i.e., to position the back engaging part 53 and the hole 25 with respect to each other. As a result, the back engaging part 53 can smoothly engage with the back engaged part 25a. Since the front engaging part 54 is positioned forward, the worker can easily recognize visually the position of the hole 26 in the process of attaching the partial panel 51L to the housing 21. Consequently, the worker can smoothly perform the work of attaching the partial panel 51L to the device body 20.

The front engaged part 26a may be positioned back away from the front end of the upper surface 22a of the device body 20 (i.e., positioned back away from the front surface 20b (see FIG. 5) of the device body 20). In other words, the front engaging part 54 may be positioned back away from the front edge 51b of the partial panel 51L.

### [Shapes of the engaging parts and engaged parts]

As depicted in FIG. 7A, the back engaged part 25a may be a protruding part protruding forward from the back part of the inner edge of the hole 25. The back engaging part 53 may have its underside equipped with a claw part 53a extending backward. In a state where the back engaging part 53 engages with the back engaged part 25a, the claw part 53a comes under the back engaged part 25a that is the protruding part.

At least either the lower surface of the back engaged part 25a (contact surface with the claw part 53a) or the upper surface of the claw part 53a (contact surface with the back engaged part 25a) may be bent in an arc-like manner. This makes it possible, in the work of detaching the partial panel 51L, to rotate smoothly the partial panel 51L. In the example in FIG. 7A, the lower surface of the back engaged part 25a and the upper surface of the claw part 53a are both bent in arc-like fashion.

As depicted in FIG. 7B, the front engaged part 26a may be the back part of the inner edge of the hole 26. The underside of the front engaging part 54 has a claw part 54a extending backward. In a state where the front engaging part 54 engages with the front engaged part 26a, the claw part 54a comes under the back engaged part 26a.

A slope face 54b may be formed on the claw part 54a. The slope face 54b extends obliquely upward and backward from the bottom end of the claw part 54a. In the process of attaching the partial panel 51L to the device body 20, the slope face 54b interferes with the back part of the inner edge of the hole 26 (upper surface of the front engaged part 26a), which causes the front engaging part 54 to deform elastically. The elastic deformation of the front engaging part 54 causes the claw part 54a to surmount the front engaged part 26a to make engagement therebetween.

An amount of protruding of the claw part 54a of the front engaging part 54 (width W2 in the front-back direction; see FIG. 7B) may be less than an amount of protruding of the claw part 53a of the back engaging part 53 (width W1 in the front-back direction; see FIG. 7A). A difference in protruding amount makes it easy to release the engagement between the front engaging part 54 and the front engaged part 26a when the front part of the partial panel 51L is bent upward in order to detach the partial panel 51L from the device body 20.

As depicted in FIG. 1F, the housing 21 has the back wall 28. An exhaust port D having multiple louvers 28a is formed on the back wall 28. The louvers 28a may be aligned in the right-left direction, for example.

As depicted in FIG. 1F, the louvers 28a may be tilted on one side in the right-left direction. An opening (d) is formed between two adjacent louvers 28a. As illustrated in FIG. 12, the hole 25 in which the back engaged part 25a is formed is located between two adjacent louvers 28a, and positioned above the opening (d) between the two louvers 28a.

As depicted in FIG. 4, the hole 25 may be formed obliquely in keeping with the tilt of the louvers 28a. The engaging part 53 formed on the partial panel 51L may also be formed obliquely in keeping with the hole 25, i.e., in conformity with the inclination of the louvers 28a. More specifically, in planar view of the electronic device 10, the louvers 28a may extend obliquely backward and leftward. The back engaging part 53 may also extend in the same direction. This structure of the back engaging part 53 makes it easy to secure the size of the back engaging part 53 and the size of the back engaged part 25a in the right-left direction.

### [Engaging parts and engaged parts]

As depicted in FIGS. 6A and 8, the partial panel 51L has a first fitting part 55A. For example, the first fitting part 55A may be positioned in front of the back engaging part 53 and behind the front engaging part 54. The first fitting part 55A may be a protruding part protruding from the lower surface of the partial panel 51L toward the device body 20.

As depicted in FIG. 9A, the device body 20 has its upper surface 22a furnished with a first fitted part 27A configured to be fitted with the first fitting part 55A. For example, the first fitted part 27A may be a hole configured to be fitted with the first fitting part 55A.

When the engaging parts 53 and 54 engage with the engaged part 25a and 26a, respectively, the engaged parts 25a and 26a are both positioned behind the engaging parts 53 and 54, respectively. That means the partial panel 51L can move forward with only the engaging parts 53 and 54 engaging with the respective engaged part 25a and 26a. In order to prevent this movement of the partial panel 51L, the first fitting part 55A and the first fitted part 27A are fitted with each other. This restrains the partial panel 51L from moving forward with respect to the device body 20.

For example, as depicted in FIG. 9A, the inner edge of the hole as the first fitted part 27A may have a size corresponding to a protruding part that is the first fitting part 55A. This effectively restrains the partial panel 51L from moving forward, which can prevent the engagement between the engaging parts 53 and 54 on one hand and the engaged parts 25a and 26a on the other hand from getting released unintentionally.

As discussed above, the partial panel 51L has the multiple front engaging parts 54. The number of first fitting parts 55A may be smaller than the number of front engaging parts 54. Also, the number of first fitting parts 55A may be smaller than the number of back engaging parts 53. For example, as illustrated in FIG. 2B and other drawings, there may be only one first fitting part 55A provided on each partial panel 51L.

The claw part 53a of the back engaging part 53 has a width W1 (see FIG. 7A) in the front-back direction. The claw part 54a of the front engaging part 54 has a width W2 (see FIG. 7B) in the front-back direction. The clearance between the inner edge of the hole as the first fitted part 27A and the outer peripheral surface of the first fitting part 55A may be smaller than the width W1 or W2. This makes it possible effectively to prevent the engagement between the engaging parts 53 and 54 on one hand and the engaged parts 25a and 26a on the other hand from getting released unintentionally.

As depicted in FIG. 7A, a clearance G1 is ensured between the inner edge of the hole in which the back engaged part 25a is formed and the back engaging part 53. As illustrated in FIG. 11, the clearance G1 allows the partial panel 51L to be arranged in an oblique posture, which facilitates the work of fitting the back engaging part 53 in the hole 25. The clearance between the inner edge of the hole as the first fitted part 27A (see FIG. 9A) and the outer peripheral surface of the first fitting part 55A may be smaller than the clearance G1. Note that, as indicated in FIG. 9A, the clearance between the inner edge of the hole as the first fitted part 27A and the outer peripheral surface of the first fitting part 55A may be substantially zero. That is, the outer peripheral surface of the first fitting part 55A may be in contact with the inner edge of the hole as the first fitted part 27A.

As depicted in FIG. 7B, a clearance G2 is ensured between the hole 26 in which the front engaged part 26a is formed and the front engaging part 54. In the process of attaching the partial panel 51L to the device body 20, the clearance G2 allows the front engaging part 54 to fit into the hole 26 smoothly. The clearance between the inner edge of the hole as the first fitted part 27A (see FIG. 9A) and the outer peripheral surface of the first fitting part 55A may be smaller than the clearance G2. As discussed above, the clearance between the inner edge of the hole as the first fitted part 27A and the outer peripheral surface of the first fitting part 55A may be substantially zero. That is, the outer peripheral surface of the first fitting part 55A may be in contact with the inner edge of the hole as the first fitted part 27A.

Note that, in the example in FIG. 7A, the claw part 53a extending backward is formed on the back engaging part 53. Conversely, a claw part may be formed on the engaged part 25a formed on the upper surface 22a of the housing 21. For example, the back engaged part 25a may be a protruding part protruding upward from the upper surface 22a of the housing 21. The claw part may protrude forward from this protruding part (back engaged part 25a). The edge of a recessed part formed on the partial panel 51L is allowed to function as the back engaging part 53. The back engaging part 53 (edge of the recessed part) may engage with the claw part formed on the back engaged part 25a.

Also, in the example in FIG. 7B, the claw part 54a extending backward is formed on the front engaging part 54. Conversely, a claw part may be formed on the engaged part 26a formed on the upper surface 22a of the housing 21. For example, the back engaged part 26a may be a protruding part protruding upward from the upper surface 22a of the housing 21. The claw part may protrude forward from this protruding part (back engaged part 26a). The edge of a recessed part formed on the partial panel 51L is allowed to function as the front engaging part 54. Then, the front engaging part (edge of the recessed part) may engage with the claw part formed on the back engaged part 26a.

As discussed above, in a case where the claw part is formed on each of the engaged parts 25a and 26a of the housing 21, the clearance between the inner edge of the hole as the first fitted part 27A (see FIG. 9A) and the first fitting part 55A may be smaller than the width of this claw part.

As depicted in FIG. 6B, the partial panel 51L has a second fitting part 55B. For example, the second fitting part 55B may be positioned in front of the back engaging part 53 and behind the front engaging part 54. Alternatively, the second fitting part 55B may be positioned in front of the first fitting part 55A. As with the first fitting part 55A, the second fitting part 55B may be a protruding part protruding from the lower surface of the partial panel 51L toward the device body 20.

As depicted in FIG. 9B, the device body 20 has its upper surface 22a furnished with a second fitted part 27B configured to be fitted with the second fitting part 55B. For example, the second fitted part 27B may be a hole configured to be fitted with the second fitting part 55B.

As depicted in FIG. 9B, the size of the inner edge of the hole as the second fitted part 27B in the right-left direction may correspond to the size of the protruding part as the second fitting part 55B in the right-left direction. Unlike the first fitting part 55A, the second fitting part 55B may have a gap G3 with respect to the second fitted part 27B in the front-back direction.

The fitting parts 55A and 55B and the fitted parts 27A and 27B restrain the movement of the partial panel 51L with regard to the device body 20. More specifically, the parallel displacement of the partial panel 51L in the front-back and right-left directions and the rotation of the partial panel 51L on a horizontal plane are restrained.

As depicted in FIGS. 9A and 9B, unlike on the engaging parts 53 and 54, no claw part is formed on the fitting parts 55A and 55B. For example, the fitting parts 55A and 55B may each have a columnar base 55a and a guided part 55b that extends downward from the base 55a and tapers toward its tip (i.e., the diameter diminishes gradually toward the tip).

As depicted in FIGS. 9A and 9B, the contact surfaces between the fitting parts 55A and 55B on one hand and the fitted parts 27A and 27B on the other hand may substantially be perpendicular to the horizontal direction. For example, the outer peripheral surface of the base 55a of the first fitting part 55A and the inner surface of the hole as the first fitted part 27A may substantially be perpendicular to the front-back and right-left directions. This makes it possible effectively to inhibit the movement of the partial panel 51L with respect to the device body 20 (i.e., movement in the front-back and right-left directions).

Also, as depicted in FIG. 9B, the outer peripheral surface of the base 55a of the second fitting part 55B and the inner surface of the hole as the second fitted part 27B may substantially be perpendicular to the right-left direction. This makes it possible effectively to inhibit the movement of the partial panel 51L with regard to the device body 20 (i.e., rotation on the horizontal plane).

As depicted in FIG. 11, in the process of attaching the partial panel 51L to the device body 20, the back engaging part 53 is first caused to engage with the back engaged part 25a. Then, the front edge 51b of the partial panel 51L is caused to approach the device body 20. This causes the claw part 54a of the front engaging part 54 of the partial panel 51L to interfere with the edge of the hole 26 (engaged part 26a in the example in the drawing) of the device body 20. At the time when the claw part 54a interferes with the upper side of the edge of the hole 26, the first fitting part 55A fits at least partially into the first fitted part 27A. This restrains the partial panel 51L from moving forward. In turn, the front engaging part 54 is elastically deformed, causing the claw part 54a to engage with the front engaged part 26a. When the claw part 54a interferes with the upper side of the edge of the hole 26, the second fitting part 55B may fit at least partially into the second fitted part 27B.

### [Structure to prevent overloading on the engaging parts]

As depicted in FIG. 1C, the left edge 51c of the left partial panel 51L protrudes leftward beyond the left side surface 20d of the device body 20. Thus, if the electronic device 10 falls with its left side facing down, causing the left edge 51c to collide with the floor, the relative positional relation between the device body 20 and the left partial panel 51L is disrupted, which significantly overloads the engaging parts 53 and 54 of the left partial panel 51L.

In order to prevent overloading on the engaging parts 53 and 54 upon falling of the electronic device 10, a guide surface 54c may be formed on the right side of the front engaging part 54, as depicted in FIG. 6B. The guide surface 54c may be a slope inclined in the right-left direction.

When the device body 20 is caused to move left relative to the left partial panel 51L, the guide surface 54c guides the inner edge of the hole 26 to release the engagement between the front engaging part 54 and the front engaged part 26a. This allows the back engaging part 53 to disengage from the hole 25, which detaches the left partial panel 51L from the device body 20. This can prevent overloading on the engaging parts 53 and 54.

Alternatively, on the right partial panel 51R of the upper exterior panel 51, the guide surface 54c may be formed on the left side of the front engaging part 54. If the electronic device 10 falls with its right side facing down, causing the right edge 51d of the right partial panel 51R to collide with the floor, the guide surface 54c guides the inner edge of the hole 26 to release the engagement between the front engaging part 54 and the front engaged part 26a. As a result, the right partial panel 51R is detached from the device body 20. This can prevent overloading on the engaging parts 53 and 54.

The slope for nudging the partial panel 51L to be detached from the device body 20 may be formed not on the front engaging part 54 but on the back engaging part 53. As another alternative, the slope may be formed not on the engaging part 53 or 54 but on the inner edge of the holes 25 and 26.

As depicted in FIG. 1D, the front edge 51b of the left partial panel 51L protrudes forward beyond the front surface 20b of the device body 20. Thus, if the electronic device 10 falls with its front side facing down, causing the front edge 51b to collide with the floor, the relative positional relation between the device body 20 and the left partial panel 51L is disrupted, which significantly overloads the engaging parts 53 and 54 of the left partial panel 51L.

In order to prevent overloading on the engaging parts 53 and 54 upon falling of the electronic device 10, the partial panel 51L may have an auxiliary fitting part 56 as depicted in FIGS. 6B and 10. For example, the auxiliary fitting part 56 may be formed along the front edge 51b of the partial panel 51L together with the front engaging part 54. A fitted part 29 (see FIG. 10) configured to be fitted with the auxiliary fitting part 56 may be formed on the upper surface 22a of the device body 20. For example, the auxiliary fitting part 56 may be a protruding part protruding from the lower surface of the partial panel 51L toward the device body 20. The fitted part 29 may be a hole configured to be fitted with this protruding part.

As depicted in FIG. 10, the auxiliary fitting part 56 has a support surface 56a facing backward. Meanwhile, the inner surface of the hole as the fitted part 29 has a supported surface 29c facing the support surface 56a in the front-back direction. If the electronic device 10 falls, causing the front edge 51b to collide with the floor, this structure reduces the load on the engaging parts 53 and 54 by imparting the load on the auxiliary fitting part 56 as well. Unlike the engaging parts 53 and 54, the support surface 56a has no claw part formed thereon.

As depicted in FIG. 1D, the back edge 51a of the left partial panel 51L protrudes backward beyond the back surface 20a of the device body 20. Thus, if the electronic device 10 falls with its back side facing down, the back edge 51a collides with the floor. Since the engaged parts 25a and 26a are both positioned behind the engaging parts 53 and 54, respectively, the collision of the back edge 51a with the floor releases the engagement between the engaging parts 53 and 54 on one hand and the engaged parts 25a and 26a on the other hand. This allows the partial panel 51L to be detached smoothly from the device body 20.

As depicted in FIG. 10, the auxiliary fitting part 56 may have a guide surface 56b on the opposite side of the support surface 56a. The guide surface 56, which is a slope, allows the auxiliary fitting part 56 to disengage smoothly from the hole as the fitted part 29 if the electronic device 10 falls with its back side facing down.

As discussed above, unlike on the engaging parts 53 and 54, no claw part is formed on the fitting parts 55A and 55B. For this reason, if the electronic device 10 falls, causing the edge of the partial panel 51L to collide with the floor, the fitting parts 55A and 55B disengage smoothly from the fitted parts 27A and 27B. This can prevent overloading on the fitting parts 55A and 55B.

The fitting parts 55A and 55B each have the base 55a (see FIGS. 9A and 9B) with its outer peripheral surface positioned in the up-down direction. The base 55a prevents the partial panel 51L from moving in the front-back and right-left directions with respect to the device body 20. However, the base 55a is limited in height. Specifically, the base 55a does not exceed in height a lower surface 22b of the upper wall 22. As a result, if the electronic device 10 falls, causing the edge of the partial panel 51L to collide with the floor, the fitting parts 55A and 55B disengage smoothly from the fitted parts 27A and 27B.

### [Partial panels and electronic device of other examples]

FIGS. 13A through 13F are views depicting the right partial panel 51R of the upper exterior panel 51. The right partial panel 51R has the engaging parts 53 and 54, the first fitting part 55A, and the auxiliary fitting part 56.

FIGS. 14A through 14F are views depicting the left partial panel 52L of the lower exterior panel 52. The left partial panel 52L has the engaging parts 53 and 54, the first fitting part 55A, the second fitting part 55B, and the auxiliary fitting part 56.

FIGS. 15A through 15F are views depicting the right partial panel 52R of the lower exterior panel 52. The right partial panel 52R has the engaging parts 53 and 54, the first fitting part 55A, and the auxiliary fitting part 56.

FIGS. 16A through 16H are views depicting an electronic device 110 as a modification example of the electronic device proposed by the present disclosure. The electronic device 110 has a device body 120 and the upper exterior panel 51 furnished with the left partial panel 51L and the right partial panel 51R discussed above. The electronic device 110 also has a lower exterior panel 152. The lower exterior panel 152 has a left partial panel 152L and the right partial panel 52R. The device body 120 is equipped with an optical disk drive. The left partial panel 152L has its front surface provided with an insertion slot 152a (see FIG. 6B) for optical disks.

FIGS. 17A through 17F are views depicting the left partial panel 152L illustrated in FIG. 16A and other drawings. As with the left lower panel 52L, the left partial panel 152L has the engaging parts 53 and 54, the first fitting part 55A, the second fitting part 55B, and the auxiliary fitting part 56.

### [Conclusion]

(1) An electronic device proposed according to the present disclosure has a device body having a first outer surface, and an exterior panel configured to cover the first outer surface. The exterior panel has a first engaging part, a second engaging part, and a fitting part, the first engaging part being positioned on a first side relative to a center of the exterior panel in a first direction, the second engaging part being positioned on a second side opposite to the first side in the first direction to a center of the exterior panel. The device body has a first engaged part, a second engaged part, and a fitted part, the first engaged part being configured to be engaged with the first engaging part, the second engaged part being configured to be engaged with the second engaging part, the fitted part being configured to be fitted with the fitting part. The first engaged part is positioned on the first side in the first direction relative to the first engaging part. The second engaged part is positioned on the first side in the first direction relative to the second engaging part. The fitted part is fitted with the fitting part so as to restrain the exterior panel from moving toward the second side in the first direction. Since the first engaged part and the second engaged part are both positioned on the first side relative to the first engaging part and the second engaging part in this electronic device, it is possible to easily release the engagement between the first engaging part and the first engaged part as well as the engagement between the second engaging part and the second engaged part. This facilitates the work of detaching the exterior panel. Further, the fitting part inhibits the exterior panel from getting unintentionally separated from the device body.
(2) In the electronic device stated in paragraph (1) above, the first engaging part and the second engaging part may each be a protruding part protruding toward the device body. The device body may have a first hole configured to be fitted with the first engaging part and a second hole configured to be fitted with the second engaging part. An edge of the first hole may be equipped with the first engaged part, and an edge of the second hole may be equipped with the second engaged part.
(3) In the electronic device stated in paragraph (1) or (2) above, the exterior panel has a first edge and a second edge positioned opposite to each other in the first direction. When the first engaging part engages with the first engaged part and the second engaging part does not engage with the second engaged part, the first exterior panel is rotatable around the first engaging part in a direction in which the second edge is separated from the device body and in a direction in which the second edge approaches the device body. This configuration allows the exterior panel to be attached to and detached from the device body with simple work. For example, with the first engaging part engaging with the first engaged part, rotating the exterior panel in a manner causing the second edge to approach the device body allows the exterior panel to be attached to the device body. When the exterior panel is to be detached, bending that portion of the exterior panel where the second engaging part is formed can release the engagement between the second engaging part and the second engaged part. Then, rotating the exterior panel in a manner causing the second edge to be separated from the device body can release the engagement between the first engaging part and the first engaged part. This allows the exterior panel to be detached from the device body.
(4) In the electronic device stated in paragraph (3) above, a distance from the second edge to the second engaging part may be greater than a distance from the first edge to the first engaging part. In this configuration, bending that portion of the exterior panel where the second engaging part is formed can release easily the engagement between the second engaging part and the second engaged part.
(5) In the electronic device stated in any one of paragraphs (1) through (3) above, either the first engaging part or the first engaged part may have a first claw part protruding therefrom. Either the second engaging part or the second engaged part may have a second claw part protruding therefrom. Either the fitting part or the fitted part may be a protruding part and the other part may be a hole configured to be fitted with the protruding part. A clearance between the protruding part and an inner surface of the hole is smaller than an amount of protruding of the first claw part and an amount of protruding of the second claw part. This configuration enables the fitting part and the fitted part to prevent the exterior panel from moving in a manner releasing the engagement between the first claw part and the second claw part.
(6) In the electronic device stated in any one of paragraphs (1) through (4) above, the first engaging part may be a protruding part protruding toward the device body. The device body may have a first hole configured to be fitted with the first engaging part. An edge of the first hole may be equipped with the first engaged part. The fitted part may be a third hole formed in the device body. A clearance between an edge of the third hole and the fitting part may be smaller than a clearance between the edge of the first hole and the first engaging part.
(7) In the electronic device stated in any one of paragraphs (1) through (6) above, the second engaging part may be a protruding part protruding toward the device body. The device body may have a second hole configured to be fitted with the second engaging part. An edge of the second hole may be equipped with the second engaged part. The fitted part may be a third hole formed in the device body. A clearance between an edge of the third hole and the fitting part may be smaller than a clearance between the edge of the second hole and the second engaging part.
(8) In the electronic device stated in any one of paragraphs (1) through (6) above, either the fitting part or the fitted part may be a protruding part configured to fit with the other part. The protruding part need not have the claw part configured to engage with the other part.
(9) Another electronic device proposed according to the present disclosure has a device body having a first outer surface, and an exterior panel configured to cover the first outer surface. The exterior panel has a first edge and a second edge positioned opposite to each other in a first direction, a first engaging part formed on a side of the first edge relative to a center of the exterior panel in the first direction, and a second engaging part formed on a side of the second edge relative to the center of the exterior panel. When the first engaging part engages with the first engaged part and the second engaging part does not engage with the second engaged part, the first exterior panel is rotatable around the first engaging part in a direction in which the second edge is separated from the device body and in a direction in which the second edge approaches the device body. A distance from the second edge to the second engaging part is greater than a distance from the first edge to the first engaging part. In this electronic device, the exterior panel can be attached to and detached from the device body with simple work. For example, with the first engaging part engaging with the first engaged part, rotating the exterior panel in a manner causing the second edge to approach the device body allows the exterior panel to be attached to the device body. When the exterior panel is to be detached, bending that portion of the exterior panel where the second engaging part is formed can release the engagement between the second engaging part and the second engaged part.
(10) An exterior panel proposed according to the present disclosure has a first edge and a second edge positioned opposite to each other in a first direction, a first engaging part formed on a first side relative to a center of the exterior panel in the first direction, the first engaging part being configured to engage with a first engaged part formed on the device body, a second engaging part formed on a second side relative to the center of the exterior panel in the first direction, the second engaging part being configured to engage with a second engaged part formed on the device body, and a fitting part configured to fit with a fitted part formed on the device body. The first engaging part has a claw part protruding on the first side in the first direction. The second engaging part has a claw part protruding on the first side in the first direction. With this exterior panel, the claw part of the first engaged part and the claw part of the second engaged part both protrude on the first side. This makes it easy to release the engagement between the first engaging part and the first engaged part as well as the engagement between the second engaging part and the second engaged part. Further, the fitting part can prevent the exterior panel from getting unintentionally separated from the device body.
(11) With the exterior panel stated in paragraph (10) above, the fitting part need not have the claw part formed thereon to engage with the fitted part.
(12) Another exterior panel proposed according to the present disclosure has a first edge and a second edge positioned opposite to each other in a first direction, a first engaging part formed on the side of the first edge relative to a center of the exterior panel in the first direction, the first engaging part being configured to engage with a first engaged part formed on the device body, and a second engaging part formed on the side of the second edge relative to the center of the exterior panel in the first direction, the second engaging part being configured to engage with a second engaged part formed on the device body. A distance from the second edge to the second engaging part is greater than a distance from the first edge to the second engaging part. With this exterior panel, the exterior panel can be detached from the device body with simple work. For example, bending that portion of the exterior panel where the second engaging part is formed can release the engagement between the second engaging part and the second engaged part.

### [Others]

The electronic device and the exterior panel proposed according to the present disclosure are not limited to the electronic device 10 and the exterior panels 51 and 52 illustrated in FIG. 1A and other drawings. There may be various changes and modifications.

For example, the structure of attaching the above-described engaging parts 53 and 54 and other parts may be applied to either the upper exterior panel 51 or the lower exterior panel 52 only. In this case, the electronic device 10 need not be furnished with the other exterior panel.

Also, in the electronic device 10, the engaging parts 53 and 54 are protruding parts, and the engaged parts 25a and 26a are formed on the inner edges of the holes formed in the device body 20. Alternatively, protruding parts may be formed as engaged parts on the device body 20, holes may be made on the exterior panels 51 and 52, and the engaging parts 53 and 54 may be formed on the inside of these holes.

Also in the electronic device 10, the fitting parts 55A and 55B are protruding parts, and the fitted parts 27A and 27B are holes made on the device body 20. Alternatively, protruding parts may be formed as the engaged parts on the device body, holes may be made on the exterior panels 51 and 52, and these holes may be allowed to function as the fitting parts.

In another example, with the front engaging part 54 of the upper exterior panel 51 engaging with the engaged part 26a of the device body 20, the upper exterior panel 51 may be rotated in a direction in which the back edge 51a of the upper exterior panel 51 approaches the device body 20 and in a direction in which the back edge 51a is separated from the device body 20. In this case, the engaged parts 25a and 26a may both be positioned in front of the engaging parts 53 and 54. This allows the user to release the engagement between the back engaging part 53 and the back engaged part 25a by bending upward the back part of the exterior panel 51.

## Claims

1. An electronic device comprising:
a device body having a first outer surface; and
an exterior panel configured to cover the first outer surface,
wherein the exterior panel has a first engaging part, a second engaging part, and a fitting part, the first engaging part being positioned on a first side relative to a center of the exterior panel in a first direction, the second engaging part being positioned on a second side opposite to the first side in the first direction to a center of the exterior panel,
the device body has a first engaged part, a second engaged part, and a fitted part, the first engaged part being configured to be engaged with the first engaging part, the second engaged part being configured to be engaged with the second engaging part, the fitted part being configured to be fitted with the fitting part,
the first engaged part is positioned on the first side in the first direction relative to the first engaging part,
the second engaged part is positioned on the first side in the first direction relative to the second engaging part, and
the fitted part is fitted with the fitting part so as to restrain the exterior panel from moving toward the second side in the first direction.

2. The electronic device according to claim 1,
wherein the first engaging part and the second engaging part are each a protruding part protruding toward the device body,
the device body has a first hole configured to be fitted with the first engaging part and a second hole configured to be fitted with the second engaging part,
an edge of the first hole is equipped with the first engaged part, and
an edge of the second hole is equipped with the second engaged part.

3. The electronic device according to claim 1,
wherein the exterior panel has a first edge and a second edge positioned opposite to each other in the first direction, and,
when the first engaging part engages with the first engaged part and the second engaging part does not engage with the second engaged part, the first exterior panel is rotatable around the first engaging part in a direction in which the second edge is separated from the device body and in a direction in which the second edge approaches the device body.

4. The electronic device according to claim 3,
wherein a distance from the second edge to the second engaging part is greater than a distance from the first edge to the first engaging part.

5. The electronic device according to claim 1,
wherein either the first engaging part or the first engaged part has a first claw part protruding therefrom,
either the second engaging part or the second engaged part has a second claw part protruding therefrom,
either the fitting part or the fitted part is a protruding part and another part is a hole configured to be fitted with the protruding part, and
a clearance between the protruding part and an inner surface of the hole is smaller than an amount of protruding of the first claw part and an amount of protruding of the second claw part.

6. The electronic device according to claim 1,
wherein the first engaging part is a protruding part protruding toward the device body,
the device body has a first hole configured to be fitted with the first engaging part, an edge of the first hole being equipped with the first engaged part,
the fitted part is a third hole formed in the device body, and
a clearance between an edge of the third hole and the fitting part is smaller than a clearance between the edge of the first hole and the first engaging part.

7. The electronic device according to claim 1,
wherein the second engaging part is a protruding part protruding toward the device body,
the device body has a second hole configured to be fitted with the second engaging part, an edge of the second hole being equipped with the second engaged part,
the fitted part is a third hole formed in the device body, and
a clearance between an edge of the third hole and the fitting part is smaller than a clearance between the edge of the second hole and the second engaging part.

8. The electronic device according to claim 4,
wherein either the fitting part or the fitted part is a protruding part configured to fit with another part, and
the protruding part has no claw part configured to engage with the other part.

9. An electronic device comprising:
a device body having a first outer surface; and
an exterior panel configured to cover the first outer surface,
wherein the exterior panel has a first edge and a second edge positioned opposite to each other in a first direction, a first engaging part formed on a side of the first edge relative to a center of the exterior panel in the first direction, and a second engaging part formed on a side of the second edge relative to the center of the exterior panel,
the device body has a first engaged part configured to be engaged with the first engaging part and a second engaged part configured to be engaged with the second engaging part,
when the first engaging part engages with the first engaged part and the second engaging part does not engage with the second engaged part, the first exterior panel is rotatable around the first engaging part in a direction in which the second edge is separated from the device body and in a direction in which the second edge approaches the device body, and
a distance from the second edge to the second engaging part is greater than a distance from the first edge to the first engaging part.

10. An exterior panel to be attached to a body of an electronic device, the exterior panel comprising:
a first edge and a second edge positioned opposite to each other in a first direction;
a first engaging part formed on a first side relative to a center of the exterior panel in the first direction, the first engaging part being configured to engage with a first engaged part formed on the device body;
a second engaging part formed on a second side relative to the center of the exterior panel in the first direction, the second engaging part being configured to engage with a second engaged part formed on the device body; and
a fitting part configured to fit with a fitted part formed on the device body,
wherein the first engaging part has a claw part protruding on the first side in the first direction, and
the second engaging part has a claw part protruding on the first side in the first direction.

11. The exterior panel according to claim 10,
wherein the fitting part has no claw part formed thereon to engage with the fitted part.

12. An exterior panel to be attached to a body of an electronic device, the exterior panel comprising:
a first edge and a second edge positioned opposite to each other in a first direction;
a first engaging part formed on a side of the first edge relative to a center of the exterior panel in the first direction, the first engaging part being configured to engage with a first engaged part formed on the device body; and
a second engaging part formed on a side of the second edge relative to the center of the exterior panel in the first direction, the second engaging part being configured to engage with a second engaged part formed on the device body,
wherein a distance from the second edge to the second engaging part is greater than a distance from the first edge to the second engaging part.
